(19) Europäisches Patentamt
European Patent Office
Office européen des brevets

(11) **EP 4 390 418 B1**

(12) **EUROPEAN PATENT SPECIFICATION**

(45) Date of publication and mention
of the grant of the patent:
**22.07.2026 Bulletin 2026/30**

(21) Application number: **23219326.8**

(22) Date of filing: **21.12.2023**

(51) International Patent Classification (IPC):
*G01R 31/367* (2019.01)   *G01R 31/3842* (2019.01)
*G01R 31/389* (2019.01)   *G01R 31/392* (2019.01)
*H01M 10/48* (2006.01)   *H02J 7/82* (2026.01)
*H02J 7/84* (2026.01)

(52) Cooperative Patent Classification (CPC):
**G01R 31/367; G01R 31/3842; G01R 31/389;
G01R 31/392; H01M 10/48; H02J 7/82; H02J 7/84;
B60L 58/10**

(54) **ELECTRONIC APPARATUS AND METHOD WITH BATTERY STATE ESTIMATION**

ELEKTRONISCHE VORRICHTUNG UND VERFAHREN MIT BATTERIEZUSTANDSSCHÄTZUNG

APPAREIL ÉLECTRONIQUE ET PROCÉDÉ AVEC ESTIMATION DE L'ÉTAT DE LA BATTERIE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **22.12.2022 KR 20220182237
03.11.2023 KR 20230150856**

(43) Date of publication of application:
**26.06.2024 Bulletin 2024/26**

(73) Proprietor: **Samsung Electronics Co., Ltd.
Suwon-si, Gyeonggi-do 16677 (KR)**

(72) Inventors:
• **Kim, Jinho
16678 Suwon-si, Gyeonggi-do (KR)**
• **Moon, Sangbin
16678 Suwon-si, Gyeonggi-do (KR)**
• **Song, Tae Won
16678 Suwon-si, Gyeonggi-do (KR)**
• **Kim, Youngjae
16678 Suwon-si, Gyeonggi-do (KR)**
• **Park, Hyukrae
16678 Suwon-si, Gyeonggi-do (KR)**
• **Heo, Jungwook
16678 Suwon-si, Gyeonggi-do (KR)**
• **Huang, Terrance Christopher
16678 Suwon-si, Gyeonggi-do (KR)**

(74) Representative: **Kuhnen & Wacker
Patent- und Rechtsanwaltsbüro PartG mbB
Prinz-Ludwig-Straße 40 A
85354 Freising (DE)**

(56) References cited:
**US-A1- 2016 209 472     US-A1- 2018 203 070
US-A1- 2018 203 072**

EP 4 390 418 B1

**Description**

BACKGROUND

1. Field

The following description relates to an electronic apparatus and method with battery state estimation.

2. Description of Related Art

A battery management system (BMS) may predict (or estimate) a battery state, such as a state of charge (SOC) and a state of health (SOH), to optimally operate a battery. Accurate estimation of a battery state by a BMS may be of importance since the scope of potential applications of a battery may be expanded according to the accuracy of predicting a battery state.

In order to enhance functions of a BMS, a complex and high-precision BMS algorithm (e.g., an electrochemical model) may be implemented.

US 2016/209472 A1 discloses a method and apparatus for estimating battery life. The method of estimating battery life comprises estimating first status information of a battery based on battery information acquired from the battery, estimating second status information of the battery using a partial cycle model corresponding to a battery degradation pattern for a partial cycle, and calculating the battery life based on a comparison between the first status information and the second status information.

It is the object of the present invention to provide an improved method for accurately estimating a battery state.

This object is solved by the subject matter of the independent claims.

Embodiments are defined by the dependent claims.

The invention is what is claimed in the independent claims. Preferred embodiments are specified in the dependent claims.

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In one or more general aspects, an electronic apparatus includes: a battery; a first calculator configured to obtain sensing data of the battery using a sensor, determine first state information of the battery using the obtained sensing data and a first battery model, and preprocess the obtained sensing data; and a second calculator configured to receive the preprocessed sensing data from the first calculator, determine an aging state of the battery using a second battery model and the received sensing data, update a parameter of the first battery model based on the determined aging state, and transmit the updated parameter to first calculator. In response to receiving the updated parameter from the second calculator, the first calculator is configured to apply the updated parameter to the first battery model such that the determined aging state is reflected in the first battery model.

The first calculator may be configured to: for the preprocessing of the obtained sensing data, obtain measurement data of a voltage of the battery; for the storing of the preprocessed sensing data, store the measurement data in the first memory; and transmit the measurement data to the second calculator in response to a transmission period being reached.

he second calculator may be configured to, for the determining of the state information, obtain estimation data of a voltage of the battery using the second battery model, estimate an aging variation of the battery based on the estimation data and the measurement data, and update an aging parameter of the second battery model using the aging variation.

The second calculator may be configured to store the updated aging parameter of the second battery model in a second memory of the second calculator and transmit the updated aging parameter stored in the second memory to the first calculator in response to detecting that the electronic apparatus enters a power-off state.

The first calculator may be configured to store the updated aging parameter received from the second calculator in the first memory of the first calculator.

For the estimating of the aging variation, the second calculator may be configured to: determine a resistance increase using a variation in the estimation data, a variation in the measurement data, and a current variation; and determine, as the aging variation, a variation in an anodic solid electrolyte interphase (SEI) resistance based on the resistance increase.

The aging parameter may include any one or any combination of any two or more of an anodic SEI resistance, a capacity of a cathode active material, and an electrode balance shift of the battery.

The second calculator may be configured to apply, in response to updating an aging parameter of the second battery model, the updated aging parameter to the second battery model, generate a plurality of pieces of basic simulation data for each of preset charging currents using the second battery model to which the updated aging parameter is applied, generate an initial look-up table (LUT) for the charging currents and preset battery voltage limits based on the plurality of pieces of basic simulation data, generate a modified LUT by adjusting one or more initial charging limit conditions of the initial LUT in response to the initial LUT failing to satisfy a preset condition, determine a final LUT based on the modified LUT in response to the modified LUT satisfying the preset condition, and control charging of the battery based on the determined final LUT.

The second calculator may be configured to transmit the determined final LUT to the first calculator.

The first calculator may be configured to store the received determined final LUT in the first memory of the first calculator.

The first calculator may be configured to transmit the determined first state information to the second calculator.

The second calculator may be configured to control a display such that the received first state information is displayed on the display.

The first state information may include state of charge (SOC) information of the battery.

The first calculator may be included in a power management integrated circuit (PMIC).

The second calculator may be included in an application processor.

In one or more non-claimed general aspects, an electronic apparatus includes: a battery; a first calculator configured to obtain sensing data of the battery using a sensor, preprocess the obtained sensing data, and store the preprocessed sensing data in a first memory; and a second calculator configured to receive the sensing data stored in the first memory from the first calculator, determine state information of the battery using a battery model and the received sensing data, and control a display such that the determined state information is displayed on the display.

The first calculator may be configured to obtain measurement data of a voltage of the battery, store the measurement data in the first memory, and transmit the measurement data to the second calculator in response to a transmission period being reached.

The second calculator may be configured to obtain estimation data of a voltage of the battery using the battery model, estimate an aging variation of the battery based on the estimation data and the measurement data, and update an aging parameter of the battery model using the aging variation.

The second calculator may be configured to store the updated aging parameter in a second memory of the second calculator and transmit the updated aging parameter stored in the second memory to the first calculator in response to detecting that the electronic apparatus enters a power-off state.

The first calculator may be configured to store the updated aging parameter received from the second calculator in the first memory.

The second calculator may be configured to determine a resistance increase using a variation in the estimation data, a variation in the measurement data, and a current variation and determine, as the aging variation, a variation in an anodic SEI resistance based on the resistance increase.

The aging parameter may include any one or any combination of any two or more of an anodic SEI resistance, a capacity of a cathode active material, and an electrode balance shift of the battery.

The second calculator may be configured to apply, in response to updating an aging parameter of the battery model, the updated aging parameter to the battery model, generate a plurality of pieces of basic simulation data for each of preset charging currents using the battery model to which the updated aging parameter is applied, generate an initial LUT for the charging currents and preset battery voltage limits based on the plurality of pieces of basic simulation data, generate a modified LUT by adjusting one or more initial charging limit conditions of the initial LUT in response to the initial LUT failing to satisfy a preset condition, determine a final LUT based on the modified LUT in response to the modified LUT satisfying the preset condition, and control charging of the battery based on the determined final LUT.

The second calculator may be configured to transmit the determined final LUT to the first calculator.

The first calculator may be configured to store the received determined final LUT in the first memory.

The first calculator may be configured to, in response to an update period being reached, estimate a charging state of the battery based on the sensing data stored in the first memory and transmit the estimated charging state to the second calculator.

The first calculator may be configured to obtain measurement data of a voltage of the battery, obtain estimation data of the voltage of the battery using the battery model, estimate an aging variation of the battery using the estimation data and the measurement data, update an aging parameter of the battery model using the aging variation, and transmit the updated aging parameter to the second calculator.

In one or more non-claimed general aspects, an operating method of an electronic apparatus includes

obtaining, using a sensor of the electronic apparatus, sensing data of a battery of the electronic apparatus; determining, using a first calculator of the electronic apparatus, first state information of the battery using the obtained sensing data and a first battery model; preprocessing, using the first calculator, the obtained sensing data; transmitting, using the first calculator, the preprocessed sensing data to a second calculator of the electronic apparatus; determining, using the second calculator, an aging state of the battery using a second battery model and the received sensing data; updating, using the second calculator, a parameter of the first battery model using the determined aging state; transmitting, using the second calculator, the updated parameter to the first calculator; and applying, using the first calculator, the updated parameter to the first battery model such that the determined aging state is reflected in the first battery model.

Other features and aspects will be apparent from the following detailed description, the drawings, and the claims.

BRIEF DESCRIPTION OF THE DRAWINGS

FIGS. 1A and 1B illustrate examples of an electronic apparatus including a plurality of calculators.

FIGS. 2 and 3 illustrate examples of operations of a plurality of calculators.

FIG. 4 illustrates an example of operations performed by a second calculator.

FIG. 5 illustrates an example of updating an aging parameter of a second battery model.

FIGS. 6 and 7 illustrate examples of updating a fast charging algorithm.

FIG. 8 illustrates an example of a mobile device.

FIG. 9 illustrates an example of a battery management system (BMS).

FIG. 10 illustrates an example of a vehicle.

FIG. 11 illustrates an example of an electronic apparatus and a cloud server.

FIG. 12 illustrates an example of an operating method of an electronic apparatus.

Throughout the drawings and the detailed description, unless otherwise described or provided, it shall be understood that the same drawing reference numerals refer to the same elements, features, and structures. The drawings may not be to scale, and the relative size, proportions, and depiction of elements in the drawings may be exaggerated for clarity, illustration, and convenience.

DETAILED DESCRIPTION

The following detailed description is provided to assist the reader in gaining a comprehensive understanding of the methods, apparatuses, and/or systems described herein. However, various changes and modifications of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

Throughout the specification, when a component or element is described as being "on", "connected to," "coupled to," or "joined to" another component, element, or layer it may be directly (e.g., in contact with the other component or element) "on", "connected to," "coupled to," or "joined to" the other component, element, or layer or there may reasonably be one or more other components, elements, layers intervening therebetween. When a component or element is described as being "directly on", "directly connected to," "directly coupled to," or "directly joined" to another component or element, there can be no other elements intervening therebetween. Likewise, expressions, for example, "between" and "immediately between" and "adjacent to" and "immediately adjacent to" may also be construed as described in the foregoing.

The terminology used herein is for the purpose of describing particular examples only and is not to be limiting of the examples. The singular forms "a", "an", and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof.

Unless otherwise defined, all terms used herein including technical or scientific terms have the same meaning as those generally understood by one of ordinary skill in the art to which this disclosure pertains and based on an understanding of the disclosure of the present application. Terms, such as those defined in commonly used dictionaries, are to be construed to have meanings matching with contextual meanings in the relevant art and the disclosure of the present application, and are not to be construed to have an ideal or excessively formal meaning unless otherwise defined herein.

As used herein, the term "and/or" includes any one and any combination of any two or more of the associated listed items. The phrases "at least one of A, B, and C", "at least one of A, B, or C", and the like are intended to have disjunctive meanings, and these phrases "at least one of A, B, and C", "at least one of A, B, or C", and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

The features described herein may be embodied in different forms, and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application. The use of the term "may" herein with respect to an example or embodiment, e.g., as to what an example or embodiment may include or implement, means that at least one example or embodiment exists where such a feature is included or implemented, while all examples are not limited thereto.

Hereinafter, examples will be described in detail with reference to the accompanying drawings. In the descriptions of the examples referring to the accompanying drawings, like reference numerals refer to like elements and any repeated description related thereto will be omitted.

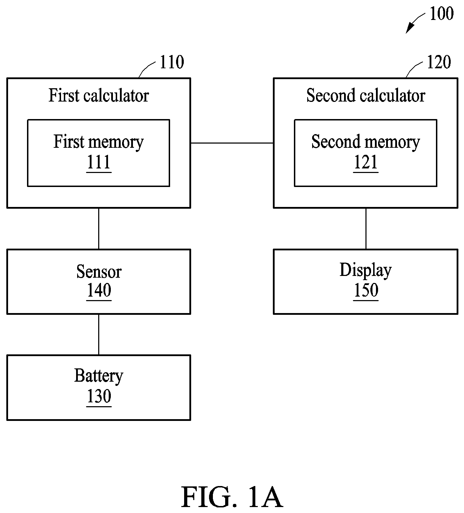

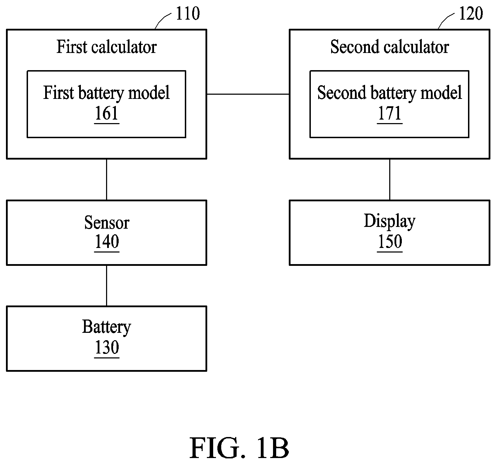

FIGS. 1A and 1B illustrate examples of an electronic apparatus including a plurality of calculators.

Referring to FIG. 1A, an electronic apparatus 100 may include a first calculator 110, a second calculator 120, and a battery 130. The electronic apparatus 100 may further include a sensor 140 and a display 150. Each of the first calculator 110 and the second calculator 120 may be or include one or more processors. For example, the first calculator 110 may be or include a first processor (e.g., one or more processors, a power management integrated circuit (PMIC), and/or a micro controller unit (MCU)) configured to perform any one, combination, or all of the operations of the first calculator 110, and the second calculator 120 may be or include a second processor (e.g., one or more processors such as an application processor) configured to perform any one, combination, or all of the operations of the second calculator 120.

A first memory 111 of the first calculator 110 may include a buffer and a first storage unit (e.g., a non-volatile memory and/or a volatile memory). A second memory 121 of the second calculator 120 may store results of an operation performed by the second calculator 120. The results of the operation performed by the second calculator 120 may include key data for operating the battery 130. To safely protect such key data, the second calculator 120 may transmit the above-mentioned key data to the first calculator 110, and the first calculator 110 may store the above-mentioned key data in the first storage unit of the first memory 111. The second memory 121 may further include a non-transitory computer-readable storage medium storing instructions that, when executed by a processor of the second calculator 120, configure the processor to perform any one, any combination, or all of the operations and methods of the second calculator 120.

As will be described later in examples, the above-mentioned key data may include, for example, an updated aging parameter of a second battery model 171 of FIG. 1B, a fast charging look-up table (LUT) updated after the updated aging parameter is applied to the second battery model 171, a number of cumulative cycles of the battery 130, a cumulative charge and discharge capacity of the battery 130, information on a fault diagnosis (e.g., whether an internal short circuit (ISC) occurs, a size of an ISC, etc.) of the battery 130, information on an expected life of the battery 130, and/or the like, but is not limited thereto.

The first calculator 110 may have a lower computation capability (or processing capability) than the second calculator 120.

In an example illustrated in FIG. 1B, the first calculator 110 may include a first battery model 161 and the second calculator 120 may include the second battery model 171. The first battery model 161 may have less complexity (e.g., technical or operational complexity) than the second battery model 171. The first battery model 161 may be a smaller-sized battery model compared to the second battery model 171. The first battery model 161 may be executed, for example, by the first calculator 110 with relatively low specifications, and the second battery model 171 may be executed, for example, by the second calculator 120 with relatively high specifications. Depending on an implementation, the first calculator 110 may not include the first battery model 161.

The type of the first battery model 161 and the type of the second battery model 171 may differ. Types of battery models may include, for example, a column counting model, an electrical circuit model, an electrochemical model, and an artificial neural network-based battery model. The electrical circuit model may have a higher level of complexity than the column counting model, the electrical circuit model may have a higher level of complexity than the electrical circuit model, and the artificial neural network-based battery model may have a higher level of complexity than the electrochemical model.

For example, the first battery model 161 may be a column counting model, and the second battery model 171 may be an electrical circuit model, an electrochemical model, or an artificial neural network-based battery model. In another example, the first battery model 161 may be an electrical circuit model, and the second battery model 171 may be an electrochemical model or an artificial neural network-based battery model. In yet another example, the first battery model 161 may be an electrochemical model, and the second battery model 171 may be an artificial neural network-based battery model.

While the type of the first battery model 161 may be the same as the type of the second battery model 171, the second battery model 171 may perform a more complex operation than the first battery model 161. For example, the first battery model 161 may be an electrical circuit model, and the second battery model 171 may be an electrical circuit model that may perform a more complex operation than the first battery model 161. In another example, the first battery model 161 may be an electrochemical model, and the second battery model 171 may be an electrochemical model that may perform a more complex operation than the first battery model 161. In yet another example, the first battery model 161 may be an artificial neural network-based battery model, and the second battery model 171 may be an artificial neural network-based battery model that may perform a more complex operation than the first battery model 161.

The first battery model 161 may be stored in the first memory 111, and the second battery 171 may be stored in the second memory 121.

The electronic apparatus 100 may be or include a mobile device, a battery management system (BMS), an electric vehicle, and/or the like, but is not limited thereto.

The electronic apparatus 100 may perform operations on the battery 130 (or battery management operations). The electronic apparatus 100 may perform the operations on the battery 130 using a plurality of calculators (e.g., 110 and 120). For example, some of the operations on the battery 130 may be performed by the first calculator 110, and the remaining operations may be performed by the second calculator 120. The electronic apparatus 100 may perform distributed processing on the operations on the battery 130 using a plurality of calculators (e.g., 110 and 120).

The operations on the battery 130 may include, for example, sensing, preprocessing, state of charge (SOC) estimation, voltage error correction, updating of the first battery model 161, updating of a parameter (e.g., an aging parameter) of the second battery model 171, updating of a fast charging algorithm, fault prediction, life estimation, and/or the like but are not limited thereto.

Of the above-mentioned operations, the "sensing" may be an operation of obtaining sensing data of the battery 130 through the sensor 140 (e.g., one or more sensors). The sensor 140 may be or include a voltage sensor, a current sensor, and/or a temperature sensor. For example, the first calculator 110 and/or the second calculator 120 may obtain voltage data of the battery 130 through the voltage sensor. The first calculator 110 and/or the second calculator 120 may obtain current data of the battery 130 through the current sensor. The first calculator 110 and/or the second calculator 120 may obtain temperature data of the battery 130 through the temperature sensor.

Of the above-mentioned operations, the "preprocessing" may be an operation of preprocessing the sensing data of the battery 130. The first calculator 110 and/or the second calculator 120 may preprocess the sensing data of the battery 130. The preprocessing may include data conversion and/or data compression.

The data conversion may be an operation of converting the sensing data into data that the electrochemical model may use to estimate an SOC of the battery 130. For example, the current data may be converted into current density data corresponding to each of cathode and anode portions by the preprocessing. The temperature data may be in Celsius and converted into data in Kelvin by the preprocessing.

The data compression may be an operation of compressing the sensing data. For example, the sensing data may be in a real number format and converted into data in an integer format by the data compression. A size of the sensing data in the integer format may be smaller than a size of the sensing data in the real number format, such that a larger amount of sensing data may be stored in the first memory 111.

According to an example, the preprocessing may include an operation of calculating at least one of various functions of the electrochemical model. For example, the first calculator 110 may calculate a function with a smallest amount of calculation among the various functions of the electrochemical model, and the second calculator 120 may calculate the remaining functions of the electrochemical model.

Of the above-mentioned operations, the "SOC estimation" may be an operation of estimating or calculating the SOC of the battery 130. For example, the first calculator 110 may estimate the SOC of the battery 130 using the sensing data of the battery 130 and the first battery model 161. However, examples are not limited thereto, and the second calculator 120 may estimate the SOC of the battery 130 using the second battery model 171 and the sensing data (e.g., the preprocessed sensing data) received from the first calculator 110.

Of the above-mentioned operations, the "voltage error correction" may be an operation of correcting an internal state of the battery model (e.g., the second battery model 171) when there is an error (i.e., a voltage error or a voltage difference) between measurement data of a voltage of the battery 130 (i.e., voltage data obtained by the voltage sensor) and estimation data of the voltage of the battery 130. The first calculator 110 and/or the second calculator 120 may perform the voltage error correction. The estimation data of the voltage of the battery 130 may be, for example, data generated by the battery model (e.g., the second battery model 171). The battery model (e.g., the second battery model 171) may estimate the voltage of the battery 130 using any one or any combination of any two or more of obtained voltage data, obtained current data, and/or obtained temperature data of the battery 130. The internal state of the battery model (e.g., the second battery model 171) may include, for example, one or a combination of two or more of a cathode lithium ion concentration distribution, an anode lithium ion concentration distribution, or an electrolyte lithium ion concentration distribution. The internal state of the battery model (e.g., the second battery model 171) is not limited to the above-mentioned examples.

For example, the first calculator 110 and/or the second calculator 120 may obtain an open circuit voltage (OCV) corresponding to a previous SOC estimated by the battery model (e.g., the second battery model 171) based on an OCV table and may determine a state variation (e.g., an SOC variation) of the battery 130 by applying a voltage error to the obtained OCV. The first calculator 110 and/or the second calculator 120 may update the internal state of the battery model (e.g., the second battery model 171) by correcting an ion concentration distribution in an active material particle or an ion concentration distribution in an electrode based on the determined state variation.

Of the above-mentioned operations, the "updating of the first battery model 161" may be an operation of updating a parameter (e.g., an aging parameter) of the first battery model 161. The first calculator 110 or the second calculator 120 may update the parameter of the first battery model 161. For example, the first battery model 161 may be a column-counting model or an electrical circuit model. In this example, the parameter (e.g., the aging parameter) of the first battery model 161 may include a parameter applied to an equivalent circuit of the battery 130. The parameter applied to the equivalent circuit may include, for example, any one or any combination of any two or more of an OCV parameter, an internal resistance parameter, or a capacity. In another example, the first battery model 161 may be an electrochemical model. In this example, parameters of the first battery model 161 may include, for example, any one or any combination of any two or more of an OCV applied to the first battery model 161, an anodic SEI resistance of the first battery model 161, a capacity of a cathode active material, or an electrode balance shift.

Of the above-mentioned operations, the "updating of an aging parameter of the second battery model 171" may be an operation of updating the aging parameter of the second battery model 171. The first calculator 110 and/or the second calculator 120 may update the aging parameter of the second battery model 171. The aging parameter is a parameter indicating an aging state of the battery 130 among a plurality of parameters included in the second battery model 171 and may include, for example, any one or any combination of any two or more of an SEI resistance, a capacity of a cathode active material, or an electrode balance shift.

For example, the first calculator 110 and/or the second calculator 120 may obtain the estimation data of the voltage of the battery 130 using the second battery model 171, estimate the aging variation of the battery 130 using the obtained estimation data and the measurement data of the voltage of the battery 130, and update the aging parameter of the second battery model 171 using the aging variation. The updating of the aging parameter of the second battery model 171 is described in detail below.

Of the above-mentioned operations, the "updating of a fast charging algorithm" may be an operation of updating an algorithm used to fast charge the battery 130 by considering the updated aging parameter. The first calculator 110 and/or the second calculator 120 may update the fast charging algorithm.

Of the above-mentioned operations, the "fault estimation" may be an operation of estimating a fault in the battery 130. For example, the "fault estimation" may include detection of an ISC of the battery 130. The first calculator 110 or the second calculator 120 may perform the detection of the ISC (or estimation of an ISC state) of the battery 130 using a battery model (e.g., the first battery model 161 to which the updated parameter is applied or the second battery model 171 to which the updated aging parameter is applied) and the sending data of the battery 130 and calculate a magnitude of an ISC resistance. When the magnitude of the ISC resistance is greater than or equal to a predetermined level, the first calculator 110 and/or the second calculator 120 may determine that the battery 130 is faulty and may notify a user that the battery 130 is faulty.

Of the above-mentioned operations, the "life estimation" may be an operation of estimating the remaining life (or a state of health (SOH)) of the battery 130. The first calculator 110 or the second calculator 120 may estimate the remaining life (or the expected life) of the battery 130 using the sensing data of the battery 130 and/or the battery model (e.g., the first battery model 161 or the second battery model 171) (or a life estimation algorithm).

Table 1 below shows examples of operations of the first calculator 110 and the second calculator 120.

Table 1:

| First calculator 110 | Second calculator 120 |
|---|---|
| Sensing | Operations on the battery 130 except for sensing |
| Sensing, preprocessing | Operations on the battery 130 except for sensing and preprocessing |
| Sensing, preprocessing, SOC estimation | Operations on the battery 130 except for sensing, preprocessing, and SOC estimation |
| Sensing, preprocessing, SOC estimation, and updating of an aging parameter of a battery model (e.g., the first battery model 161 and/or the second battery model 171) | Operations on the battery 130 except for sensing, preprocessing, SOC estimation, and updating of an aging parameter of a battery model (e.g., the first battery model 161 and/or the second battery model 171) |

The operations of the first calculator 110 and the second calculator 120 are not limited to the examples shown in Table 1 above. As described above, some of the operations on the battery 130 (or battery management operations) may be performed by the first calculator 110, and the rest of the operations on the battery 130 may be performed by the second calculator 120.

A typical electronic apparatus may use a single low-spec calculator to manage a battery, and the typical electronic apparatus may execute a lightweight model algorithm in the low-spec calculator to manage the battery. However, when an environment in which a battery is used is harsher due to fast charging, and the like, the lightweight model algorithm executed in the low-spec calculator may not be capable of managing the battery well, such that the battery may not be able to be used safely for an extended period of time. However, while a high-precision BMS algorithm (e.g., an electrochemical model) may be more precise and may provide more information on a battery, the high-precision BMS algorithm may have a larger amount of calculation than an existing BMS algorithm. Thus, it may be difficult for the typical electronic apparatus to directly apply a high-spec BMS algorithm to currently commercialized electronic apparatuses (e.g., a smartphone, a tablet, an electric vehicle, etc.). Further, a power management integrated circuit (PMIC) with enhanced calculation performance may be required to execute the high-spec BMS algorithm. However, the enhanced calculation performance may lead to an increase in a price of the PMIC.

In contrast to the typical electronic apparatus, the electronic apparatus 100 of one or more embodiments may execute the high-precision BMS algorithm (e.g., the electrochemical model) using the plurality of calculators 110 and 120. In addition, the electronic apparatus 100 of one or more embodiments may execute a BMS algorithm using the plurality of calculators 110 and 120, while limited hardware may hinder the performance of a BMS algorithm in the typical electronic apparatus. Accordingly, various BMS algorithms may be applied to the electronic apparatus 100 of one or more embodiments.

The first calculator 110 may not include the first battery model 161, and the second calculator 120 may include the second battery model 171. The second calculator 120 may determine state information (e.g., SOC) of the battery 130 using the sensing data received from the first calculator 110 and the battery model (e.g., the second battery model 171). The second calculator 120 may control the display 150 such that the determined state information is displayed on the display 150.

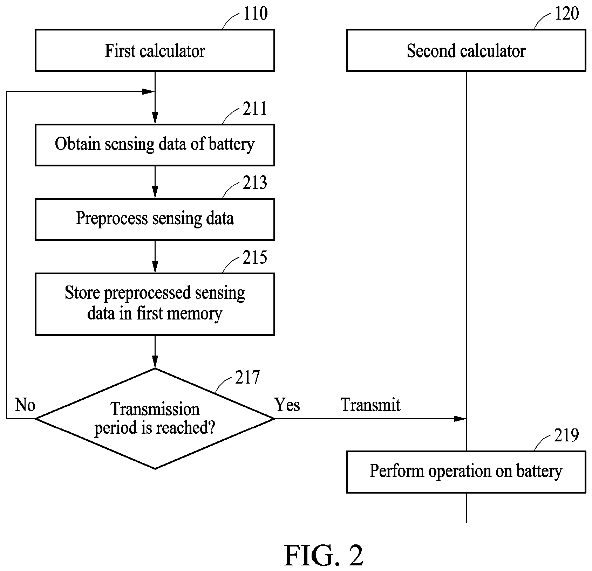

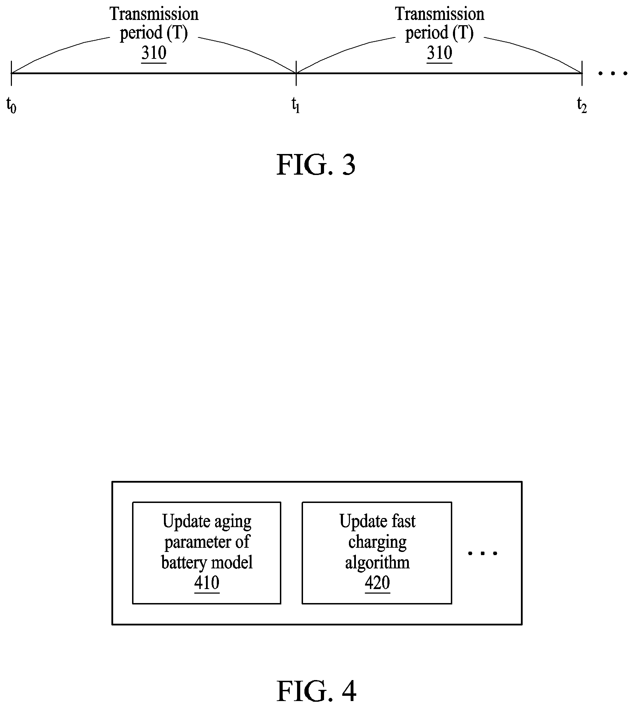

FIGS. 2 and 3 illustrate examples of operations of a plurality of calculators. Operations to be described hereinafter with reference to FIG. 2 may be performed sequentially, but not necessarily performed sequentially. For example, the order of the operations may be changed and at least two of the operations may be performed in parallel.

As illustrated in FIG. 2, the first calculator 110 may perform sensing and preprocessing, and the second calculator 120 may perform operations on the battery 130 except for the sensing and preprocessing.

Referring to FIG. 2, in operation 211, the first calculator 110 may obtain sensing data of the battery 130 (e.g., from the sensor 140).

In operation 213, the first calculator 110 may preprocess the obtained sensing data.

In operation 215, the first calculator 110 may store the preprocessed sensing data in the first memory 111 (e.g., a buffer).

In operation 217, the first calculator 110 may determine whether a transmission period is reached. For example, with reference to FIG. 3, a sensing starting time point of the first calculator 110 may be $t_0$, and a current time point may be $t_1$. In this example, when the current time point of $t_1$ is reached after the sensing starting of $t_0$, the first calculator 110 may determine that a transmission period 310 is reached.

Referring back to FIG. 2, the first calculator 110 may transmit the sensing data stored in the first memory 111 (e.g., the buffer) to the second calculator 120 when the transmission period is reached. When the transmission period is not reached, the first calculator 110 may perform operation 211.

The first calculator 110 may perform SOC estimation. For example, the first calculator 110 may estimate (or determine) the SOC of the battery 130 using the first battery model 161 and sensing data (e.g., sensing data during the transmission period 310 or sensing data during a separate SOC update period). The first calculator 110 may transmit the SOC of the battery 130 to the second calculator 120.

When receiving the sensing data from the first calculator 110, the second calculator 120 may perform an operation on the battery 130 in operation 219. Hereinafter, an example of operation 219 is described.

The second calculator 120 may receive information (e.g., the sensing data of the battery 130, etc.) required to update the first battery model 161 from the first calculator 110. The second calculator 120 may estimate (or determine) an aging state of the battery 130 using the second battery model 171 and the information (e.g., the received sensing data, etc.) received from the first calculator 110. The aging state may, for example, indicate the degree to which the battery 130 is aged. The battery 130 may age with use, and as the battery 130 ages, the OCV, capacity, and internal resistance of the battery 130 may change. In order to reflect this change in the first battery model 161, the second calculator 120 may update parameters (e.g., an OCV parameter, a capacity parameter, and an internal resistance parameter) of the first battery model 161 based on the estimated aging state of the battery 130 and transmit the updated parameters to the first calculator 110. Updating the parameters may mean, for example, determining (or changing or updating) a value of each parameter to match the estimated aging state of the battery 130.

For example, the second calculator 120 may determine (or calculate) the value of a first parameter (e.g., an OCV parameter) of the first battery model 161 to correspond to the estimated aging state of the battery 130. Alternatively, as described below, the second calculator 120 may update an aging parameter of the second battery model 171 and reflect the updated aging parameter in the second battery model 171. As the updated aging parameter is reflected in the second battery model 171, the value of the OCV of the second battery model 171 may also change. The second calculator 120 may determine, as the value of the first parameter (e.g., the OCV parameter) of the first battery model 161, the changed value of the OCV of the second battery model 171.

The second calculator 120 may determine the value of a second parameter (e.g., a capacity parameter) and the value of a third parameter (e.g., an internal resistance parameter) of the first battery model 161 using the changed value of the first parameter (e.g., the OCV parameter) of the first battery model 161 (or using the estimated aging state of the battery 130). The second calculator 120 may transmit the determined value of each of the parameters of the first battery model 161 to the first calculator 110.

The first calculator 110 may reflect (or apply) the parameters (e.g., the determined value of each of the parameters of the first battery model 161) of the first battery model 161 updated by the second calculator 120 in the first battery model 161. For example, prior to updating the parameters of the first battery model 161, the value of the OCV parameter of the first battery model 161 may be OCV1, the value of the capacity parameter may be C1, and the value of the internal resistance parameter may be R1. The second calculator 120 may determine the value of the OCV parameter (e.g., OCV2), the value of the capacity parameter (e.g., C2), and the value of the internal resistance parameter (e.g., R2) of the first battery model 161 to correspond to the estimated aging state of the battery 130. The first calculator 110 may receive the value of the OCV parameter (e.g., OCV2), the value of the capacity parameter (e.g., C2), and the value of the internal resistance parameter (e.g., R2) of the first battery model 161 from the second calculator 120. The first calculator 110 may change the value of the OCV parameter of the first battery model 161 from OCV1 to OCV2, change the value of the capacity parameter of the first battery model 161 from C1 to C2, and change the value of the internal resistance parameter of the first battery model 161 from R1 to R2. Accordingly, the estimated aging state of the battery 130 may be reflected in the first battery model 161, and thus, the first battery model 161 may determine the SOC of the battery 130 in accordance with the estimated aging state of the battery 130.

Depending on an implementation, the second calculator 120 may determine the value of the first parameter (e.g., the OCV parameter) of the first battery model 161 to correspond to the estimated aging state of the battery 130 and transmit the determined value of the first parameter to the first calculator 110. The first calculator 110 may determine the value of the second parameter (e.g., the capacity parameter) and the value of the third parameter (e.g., the internal resistance parameter) of the first battery model 161 based on the determined value of the first parameter.

An update condition of an aging parameter of the second battery model 171 may be satisfied. The update condition may be determined based on any one or any combination of any two or more of a number of cycles of the battery 130, a cumulative use capacity of the battery 130, a cumulative use time of the battery 130, and a number of aging variations stored in a memory (e.g., the first memory 111 or a second memory 121). For example, to update an aging parameter using multiple aging variations accumulated as the battery 130 is charged and discharged several times, any one or any combination of any two or more of the number of cycles of the battery 130, the cumulative use capacity of the battery 130, the cumulative use time of the battery 130, and the number of aging variations stored in the memory may be used as the update condition. The update condition may be set independently for each of the anodic SEI resistance, the capacity of a cathode active material, and the electrode balance shift, such that a predetermined aging parameter may be more frequently updated than other aging parameters. However, the example of the update condition is not limited thereto.

When the update condition of the aging parameter of the second battery model 171 is satisfied, the second calculator 120 may update the aging parameter of the second battery model 171 based on an estimated aging variation (e.g., a variation in the anodic SEI resistance, etc.). The second calculator 120 may store the updated aging parameter (or the estimated aging variation) in the second memory 121.

The second calculator 120 may update a fast charging algorithm by considering the updated aging parameter. For example, when the aging parameter of the second battery model 171 is updated, the second calculator 120 may apply the updated parameter to the second battery model 171. The second calculator 120 may generate basic simulation data for preset charging currents using the second battery model 171 to which the updated aging parameter is applied. The second calculator 120 may generate an initial look-up table (LUT) for the charging currents and preset battery voltage limits based on the basic simulation data. When the initial LUT fails to satisfy a preset condition, the second calculator 120 may generate a modified LUT by adjusting one or more of initial charging limit conditions of the initial LUT. When the modified LUT satisfies the preset condition, the second calculator 120 may determine the final LUT based on the modified LUT. The second calculator 120 (or the first calculator 110) may control charging (e.g., fast charging) of the battery 130 based on the determined final LUT. Examples of updating of the fast charging algorithm are described in detail later.

For reference, the determined final LUT may correspond to the updated fast charging LUT described with reference to FIGS. 1A and 1B.

The second calculator 120 may detect an ISC of the battery 130 using the sensing data received from the first calculator 110 and the second battery model 171. When the detected ISC is greater than or equal to a predetermined level, the second calculator 120 may determine that the battery 130 is in a fault state.

The examples described with reference to FIGS. 2 and 3 may apply to an example in which the first calculator 110 may include the first battery model 161 and the second calculator 120 may include the second battery model 171. In addition, the description provided with reference to FIGS. 2 and 3 may apply to an example in which the first calculator 110 may not include the first battery model 161 and the second calculator 120 may include the second battery model 171.

FIG. 4 illustrates an example of operations performed by a second calculator.

Referring to FIG. 4, operation 410 may be an operation of updating an aging parameter of a battery model (e.g., the first battery model 161 and/or the second battery model 171), and operation 420 may be an operation of updating a fast charging algorithm. Operations 410 and 420 of FIG. 4 are described as being performed by the second calculator 120, but this is merely an example, and some of operations 410 and 420 of FIG. 4 may be performed by the first calculator 110 according to examples.

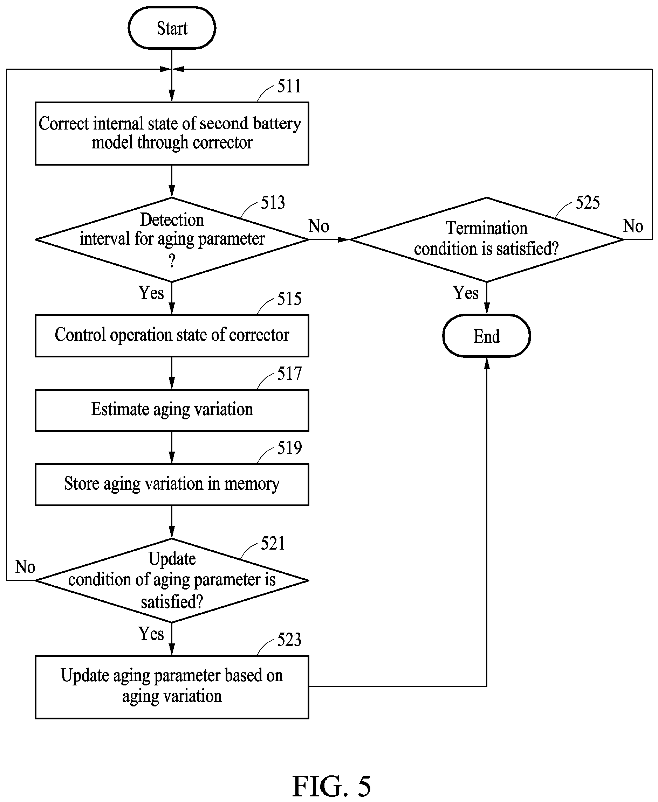

The second calculator 120 may update an aging parameter of the second battery model 171, which is described later with reference to FIG. 5.

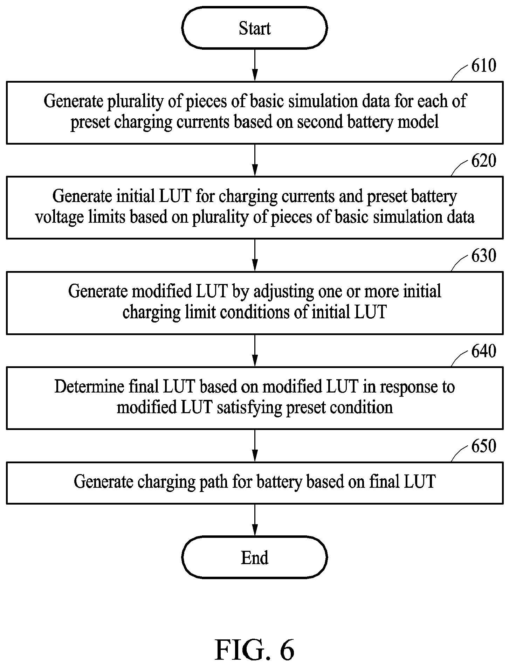

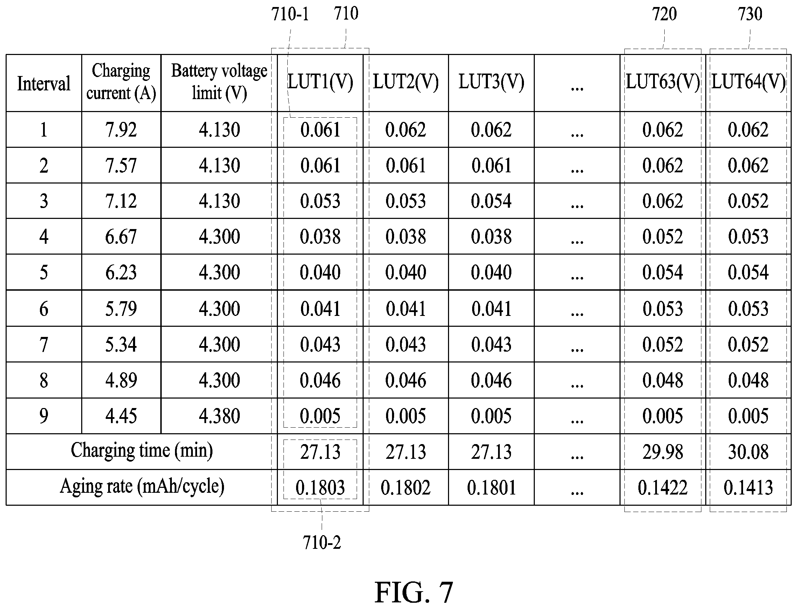

The second calculator 120 may update a fast charging algorithm, which is described later with reference to FIGS. 6 and 7.

FIG. 5 illustrates an example of updating an aging parameter of a second battery model. Operations to be described hereinafter with reference to FIG. 5 may be performed sequentially but not necessarily. For example, the order of the operations may be changed and at least two of the operations may be performed in parallel.

Operations 511 to 525 of FIG. 5 may be included in operation 410 of FIG. 4.

Referring to FIG. 5, in operation 511, the second calculator 120 may correct an internal state (and/or SOC) of the second battery model 171 through a corrector. Through this correction, measurement data of a voltage of the battery 130 and estimation data of the voltage of the battery 130 may almost be the same.

In operation 513, the second calculator 120 may determine whether a current state of the battery 130 corresponds to a detection interval for an aging parameter. For example, the second calculator 120 may determine whether the current state of the battery 130 corresponds to the detection interval for the aging parameter using an estimated SOC (or an estimated voltage) of the battery 130.

The aging parameter may include any one or any combination of any two or more of an anodic SEI resistance, a capacity of a cathode active material, and an electrode balance shift of the battery. Operations 513 to 523 may be performed independently for each aging parameter and will be described separately for each aging parameter.

First, a case where the aging parameter is the anodic SEI resistance is described.

In operation 513, the second calculator 120 may determine whether the current state of the battery 130 corresponds to the detection interval for the aging parameter using the estimated SOC of the battery. In the case of the anodic SEI resistance, the aging parameter may be estimated in various SOC ranges. However, accuracy of the electrochemical model may be high within a high SOC interval in which a resistance value is small. Thus, the aging parameter may be estimated within the high SOC interval. Furthermore, a corrector may be turned off or the correction strength of the corrector may be reduced in order to estimate the anodic SEI resistance. However, when the corrector is turned off or the correction strength is reduced within an interval that is different from an interval in which the capacity of a cathode active material is estimated, a proportion occupied by the corrector OFF interval or reduced correction strength interval in an entire operation interval may increase. To minimize the corrector OFF interval or reduced correction strength interval, the anodic SEI resistance may be estimated together when the corrector is turned off (or when the correction strength is reduced) for estimating the capacity of the cathode active material. For example, a detection interval for the anodic SEI resistance may be set to be the same as a detection interval for the capacity of the cathode active material. In summary, the second calculator 120 may determine whether the current state of the battery 130 corresponds to the detection interval for the aging parameter based on whether the estimated SOC of the battery 130 is greater than a predetermined threshold or falls within a predetermined range. Further, since the SOC of the battery 130 has a predetermined correlation with an ion concentration and the capacity for active material of the battery 130, the second calculator 120 may determine whether the current state of the battery 130 corresponds to the detection interval for the aging parameter based on whether either one of the ion concentration and the capacity for active material of the battery 130 is greater than the predetermined threshold or falls within the predetermined range.

In operation 515, the second calculator 120 may control the corrector to be in an OFF state for a predetermined period of time or control the corrector to be in a state in which the correction strength of the corrector is reduced to a predetermined level or less (e.g., a state below the correction strength of the corrector in operation 511) for estimating the anodic SEI resistance. When the time elapses, the second calculator 120 may control the corrector to be back in an ON state or revert the correction strength of the corrector to the original level (e.g., the correction strength level of the corrector in operation 511).

While performing the estimation of an anodic SEI resistance, the second calculator 120 may not perform correction on or correct the internal state of the second battery model 171 at a correction strength level below a predetermined level. Considering that a correction level (e.g., the correction level of the corrector in operation 511) that closely matches measurement data of the voltage of the battery 130 and the estimation data of the voltage of the battery 130 is a normal level, the correction strength below the predetermined level may be, for example, correction strength less than n% of the normal level. n may be a positive number less than 100 and may be adjusted by the second calculator 120. For example, the voltage difference between the measurement data of the voltage of the battery 130 and the estimation data of the voltage of the battery 130 may be 30 millivolts (mV), and n may be 10. Normal level correction may represent the correction that reduces a 30 mV voltage difference to 0 mV. Normal level correction may represent the correction that corrects a 30 mV voltage difference to 0 mV. Correction with the correction strength below the predetermined level may represent the correction that corrects 3 mV (= 10% of 30 mV) of a 30 mV voltage difference while allowing a 27 mV voltage difference. For example, the correction with the correction strength below the predetermined level may recognize the 30 mV voltage difference as the 3 mV voltage difference and represent the correction of the 3 mV voltage difference. Alternatively, the correction with the correction strength below the predetermined level may be correction that corrects 10% of a total voltage difference (e.g., 30 mV) such that the 30 mV voltage difference decreases to the 27 mV voltage difference. The description of the correction strength below the predetermined level is not limited to the above-described examples.

In operation 517, the second calculator 120 may estimate an aging variation of the battery 130 using measurement data of a voltage of the battery 130 and estimation data of the voltage of the battery 130. For example, the second calculator 120 may determine a resistance increase based on a variation in the measurement data on the voltage of the battery 130, a variation in the estimation data on the voltage of the battery 130, and a current variation and determine, as the aging variation, the anodic SEI resistance based on the resistance increase.

In operation 519, the second calculator 120 may store an estimated aging variation (e.g., the variation in the anodic SEI resistance) in a memory (e.g., the second memory 121).

In operation 521, the second calculator 120 may determine whether an update condition of the anodic SEI resistance is satisfied. The second calculator 120 may perform operation 523 when the update condition is satisfied and perform operation 511 when the update condition is not satisfied.

In operation 523, the second calculator 120 may update an anodic SEI resistance value, which is an aging parameter of the second battery model 171, using one or more aging variations stored in the memory.

Some or all of model parameters of the second battery model 171 may mutually affect, and thus, a change in one model parameter may affect another model parameter. The second calculator 120 may also update model parameters of the second battery model 171, other than the anodic SEI resistance, based on the anodic SEI resistance value.

Next, a case where the aging parameter is the capacity of the cathode active material is described.

In operation 513, the second calculator 120 may determine whether the current state of the battery 130 corresponds to the detection interval for the aging parameter based on whether the estimated SOC of the battery 130 is greater than the predetermined threshold or falls within the predetermined range. Further, the second calculator 120 may determine whether the current state of the battery 130 corresponds to the detection interval for the aging parameter based on whether the estimated SOC of the battery is in an interval where a characteristic of the capacity of the cathode active material decreasing is maximized. For example, the second calculator 120 may determine whether the current state of the battery 130 corresponds to the detection interval for the aging parameter based on whether the estimated SOC of the battery 130 corresponds to a predetermined interval (e.g., an interval in which a change in an anode open circuit potential (OCP) of the battery 130 is less than or equal to a predetermined first threshold and a change in a cathode OCP of the battery 130 is greater than or equal to a predetermined second threshold). For example, in the predetermined interval, when the change in the anode OCP is insignificant, the change in the cathode OCP is significant, and the estimated SOC of the battery 130 is greater than or equal to a predetermined level, the second calculator 120 may determine that the current state of the battery 130 corresponds to the detection interval for the aging parameter.

In operation 515, the second calculator 120 may control the corrector to be in the OFF state for a predetermined period of time or control the corrector to be in a state in which the correction strength of the corrector is reduced to a predetermined level or less (e.g., a state below the correction strength of the correction in operation 511) for estimating the capacity of the cathode active material. When the time elapses, the second calculator 120 may control the corrector to be back in an ON state or revert the correction strength of the corrector to the original level (e.g., the correction strength level of the corrector in operation 511).

In operation 517, the second calculator 120 may determine that a ratio between a response characteristic of an estimated voltage and a response characteristic of a measured voltage according to one or a combination of two or more of discharging of the battery 130 and a current change.

The description of operations 519 to 523 provided above may also apply to the case where the aging parameter is the capacity of the cathode active material, and thus a further detailed description is omitted.

Lastly, a case where the aging parameter is an electrode balance shift is described.

In operation 513, the second calculator 120 may determine whether the current state of the battery 130 corresponds to the detection interval for the aging parameter based on whether one of the estimated SOC, the ion concentration, and the capacity for active material of the battery 130 is less than the predetermined threshold and/or falls within the predetermined range. Further, the second calculator 120 may determine whether the current state of the battery 130 corresponds to the detection interval for the aging parameter based on whether the current state of the battery corresponds to an interval where a characteristic of the electrode balance shift is maximized. For example, whether the current state of the battery corresponds to an interval where the characteristic of the electrode balance shift is maximized may be determined based on one of the SOC, the ion concentration, and the capacity for active material of the battery 130.

In operation 515, the second calculator 120 may control the corrector to be in an ON state for estimating the electrode balance shift.

In operation 517, the second calculator 120 may estimate or determine a degree in which the SOC value is corrected by the corrector to be the aging variation.

The description of operations 519 to 523 provided above may also apply to the case where the aging parameter is the electrode balance shift, and thus a further detailed description is omitted.

In operation 513, the second calculator 120 may determine whether a termination condition is reached. For example, the second calculator 120 may determine that the termination condition is reached when a predetermined operation time elapses. If the predetermined operation time does not elapse, operation 511 may be performed.

Through the operation of the second calculator 120 described with reference to FIG. 5, it may be possible to update the aging parameter of the second battery model 171 to actively track the aging state of the actual battery that ages differently according to a use pattern or environment of the battery 130.

Although it is described with reference to FIG. 5 that the second calculator 120 updates the aging parameter of the second battery model 171, this is merely an example, and at least some of the operations of updating the aging parameter of the second battery model 171 may be performed by the first calculator 110, and the remaining operations may be performed by the second calculator 120.

The second calculator 120 may store the updated aging parameter in the second memory 121. The second calculator 120 may transmit the updated aging parameter to the first calculator 110, and the first calculator 110 may store the updated aging parameter in the first memory 111.

When the updated aging parameter is reflected in (or applied to) the second battery model 171, there may be a parameter (e.g., an OCV) of the second battery model 171 that changes in conjunction with this reflection. The second calculator 120 may store the parameter (e.g., the OCV) of the second battery model 171 in the second memory 121. The second calculator 120 may transmit the parameter (e.g., the OCV) of the second battery model 171 to the first calculator 110, and the first calculator 110 may store the parameter (e.g., the OCV) of the second battery model 171 in the first memory 111.

The second calculator 120 may estimate or determine an SOH of the battery 130 through the second battery model 171 to which the updated aging parameter is applied. The second calculator 120 may store the estimated SOH in the second memory 121. The second calculator 120 may transmit the estimated SOH to the first calculator 110, and the first calculator 110 may store the estimated SOH in the first memory 111.

The second calculator 120 may store an intermediate variable value (e.g., the internal state of the second battery model 171, etc.) in the second memory 121, the intermediate variable value being derived while updating the aging parameter. The second calculator 120 may transmit the intermediate variable value (e.g., the internal state of the second battery model 171, etc.) to the first calculator 110, and the first calculator 110 may store the intermediate variable value (e.g., the internal state of the second battery model 171, etc.) in the first memory 111.

The examples described with reference to FIG. 5 may apply to an example in which the first calculator 110 may include the first battery model 161 and the second calculator 120 may include the second battery model 171. In addition, the description provided with reference to FIG. 5 may apply to an example in which the first calculator 110 may not include the first battery model 161 and the second calculator 120 may include the second battery model 171.

FIGS. 6 and 7 illustrate examples of updating a fast charging algorithm. Operations to be described hereinafter with reference to FIG. 6 may be performed sequentially but not necessarily. For example, the order of the operations may be changed and at least two of the operations may be performed in parallel.

In operation 610, the second calculator 120 may generate basic simulation data for preset charging currents based on the second battery model 171 to which an updated aging parameter is applied. For example, the preset charging currents may include 7.92 amperes (A), 7.57 A, 7.12 A, 6.67 A, 6.23 A, 5.79 A, 5.34 A, 4.89 A, and/or 4.45 A but are not limited thereto.

The second calculator 120 may generate the basic simulation data for a preset partial interval as a fast charging interval of a total charge capacity of the battery 130. For example, the fast charging interval of the total charge capacity may include an SOC range (e.g., 0.04 to 0.71). A maximum charging time and battery voltage limits for the charging currents may be preset to generate the basic simulation data.

First basic simulation data indicating an internal state of the battery 130 may be generated by charging the battery with a first charging current in the fast charging interval. For example, when the fast charging interval includes an SOC ranging from 0.04 to 0.71, the generation of the first basic simulation data may be terminated in response to the SOC reaching 0.71 or a battery voltage reaching a first battery voltage limit set for the first charging current. When a number of preset charging currents is n, n pieces of basic simulation data may be generated.

A side reaction current may be calculated based on basic simulation data. For example, the side reaction current may be calculated based on a Butler-Volmer equation.

The Butler-Volmer equation is a calculation formula that obtains an amount of lithium ions consumed by an anode side reaction (that is, an amount of anode side reaction) and may be expressed by Equation 1 below, for example.

Equation 1:

$$j_{side}^{Li} = a_s i_{0,side} \left[ \exp\left( \frac{\alpha_{a,side} n_{side} F}{RT} \eta_{side} \right) - \exp\left( -\frac{\alpha_{c,side} n_{side} F}{RT} \eta_{side} \right) \right]$$

In Equation 1, $j_{side}^{Li}$ denotes an electrode current density related to lithium ion consumption by an anode side reaction, wherein an amount of lithium ions consumed by the anode side reaction may be obtained by integrating $j_{side}^{Li}$ with respect to time. $a_s$ denotes an active surface area of an anode, and $i_{0,side}$ denotes an exchange current density for the anode side reaction. $\alpha_{a,side}$ denotes an anodic charge transfer coefficient, $\alpha_{c,side}$ denotes a cathodic charge transfer coefficient, and for example, the anodic charge transfer coefficient and the cathodic charge transfer coefficient may each have a value of 0.5. $n_{side}$ denotes a number of molecules involved in the anode side reaction, F denotes a Faraday constant, R denotes an ideal gas constant, and $T$ denotes a temperature. $\eta_{side}$ denotes an anode overpotential for a side reaction and may be expressed by Equation 2 below, for example.

Equation 2:

$$\eta_{side} = \phi_s - \phi_e - U_{eq,side} - \frac{R_{SEI,total}}{a_{s,side}} j_{total}^{Li}$$

In Equation 2, $\phi_s$ denotes a potential of a solid, and $\phi_e$ denotes a potential of an electrolyte. $U_{eq,side}$ denotes an equilibrium potential for the side reaction and may be set to 0.4 volts (V), for example. $R_{SEI,total}$ denotes a resistance by an SEI layer formed on an anode surface, $a_{s,size}$ denotes an active surface area of the anode, and $j_{total}^{Li}$ denotes an electrode current density related to all lithium ions.

The exchange current density $i_{0,side}$ described above may be expressed by Equation 3 below, for example.

Equation 3:

$$i_{0,side} = k_{side} \sqrt{c_{s,surf} c_{EC,Rs}}$$

In Equation 3, $k_{side}$ denotes a kinetic rate constant for the side reaction, $c_{s,surr}$ denotes a lithium ion concentration on an electrode (for example, anode) surface, and $c_{EC,Rs}$ denotes an electrolyte concentration on the electrode surface.

In operation 620, the second calculator 120 may generate an initial LUT for the charging currents and preset battery voltage limits based on the basic simulation data.

As described above, the preset charging currents may include 7.92 A, 7.57 A, 7.12 A, 6.67 A, 6.23 A, 5.79 A, 5.34 A, 4.89 A, and 4.45 A. The initial LUT for the preset charging currents is illustrated in FIG. 7.

The preset charging currents may be used to charge the battery in the fast charging interval, and the fast charging interval may be divided into intervals in which the charging currents are used. For example, an interval in which 7.92 A is used may be defined as a first interval, an interval in which 7.57 A is used may be defined as a second interval, an interval in which 7.12 A is used may be defined as a third interval, an interval in which 6.67 A is used may be defined as a fourth interval, an interval in which 6.23 A is used may be defined as a fifth interval, an interval in which 5.79 A is used may be defined as a sixth interval, an interval in which 5.34 A is used may be defined as a seventh interval, an interval in which 4.89 A is used may be defined as an eighth interval, and an interval in which 4.45 A is used may be defined as a ninth interval.

For example, the first interval may correspond to a period from a start point of the fast charging interval to a point in time at which the battery voltage reaches 4.130 V while the battery is being charged with 7.92 A. The second interval may correspond to a period from an end point of the first interval to a point in time at which the battery voltage reaches 4.130 V while the battery is being charged with 7.57 A. The third interval may correspond to a period from an end point of the second interval to a point in time at which the battery voltage reaches 4.130 V while the battery is being charged with 7.12 A. The fourth interval may correspond to a period from an end point of the third interval to a point in time at which the battery voltage reaches 4.300 V while the battery is being charged with 6.67 A. The fifth interval may correspond to a period from an end point of the fourth interval to a point in time at which the battery voltage reaches 4.300 V while the battery is being charged with 6.23 A. The sixth interval may correspond to a period from an end point of the fifth interval to a point in time at which the battery voltage reaches 4.300 V while the battery is being charged with 5.79 A. The seventh interval may correspond to a period from an end point of the sixth interval to a point in time at which the battery voltage reaches 4.300 V while the battery is being charged with 5.34 A. The eighth interval may correspond to a period from an end point of the seventh interval to a point in time at which the battery voltage reaches 4.300 V while the battery is being charged with 4.89 A. The ninth interval may correspond to a period from an end point of the eighth interval to a point in time at which the battery voltage reaches 4.380 V while the battery is being charged with 4.45 A.

An initial LUT (i.e., LUT1) 710 may be generated to represent initial charging limit conditions 710-1 of the battery 130 for intervals corresponding to the charging currents. For example, the initial charging limit conditions 710-1 may be anode potentials of the battery 130. However, examples are not limited thereto.

The initial LUT 710 may further include, as charging results 710-2, a charging time and an aging rate required when the battery 130 is charged with a charging path according to the initial LUT 710.

Referring back to FIG. 6, in operation 630, the second calculator 120 may generate a modified LUT by adjusting one or more of the initial charging limit conditions of the initial LUT.

The second calculator 120 may determine whether a charging result according to the charging path of the initial LUT satisfies a preset condition, and generate a modified LUT by adjusting one or more of the initial charging limit conditions of the initial LUT, in response to the charging result failing to satisfy the preset condition. For example, an initial charging limit condition may be an anode potential. For example, the preset condition may be whether a total charging time for the fast charging interval elapses a preset time.

For example, an anode potential limit of the first interval (e.g., the interval in which the charging current of 7.92 A is used), among the intervals of the fast charging interval, may be adjusted from 0.061 V to 0.062 V. In this example, the initial LUT and the modified LUT may be referred to as a first LUT and a second LUT, respectively.

A charging limit condition for any one interval (i.e., target interval), among the intervals of the fast charging interval, may be adjusted, and the charging limit conditions of the other intervals may not be adjusted. For example, in the initial LUT 710 of FIG. 7, only an anode potential limit for the first interval may be adjusted, and anode potential limits for the second to ninth intervals may not be adjusted.

It may be determined for the modified LUT whether a charging result according to the charging path of the modified LUT satisfies the preset condition, and a re-modified LUT may be generated by adjusting one or more of the charging limit conditions of the modified LUT in response to the charging result failing to satisfy the condition. In this case, the modified LUT and the re-modified LUT may be referred to as the second LUT and a third LUT, respectively.

In operation 640, the second calculator 120 may determine the final LUT based on the modified LUT in response to the modified (or re-modified) LUT satisfying the preset condition. For example, the preset condition may be whether the charging time of the battery 130 in the fast charging interval using the charging path of the modified LUT exceeds a preset time.

As illustrated in FIG. 7, when the preset time is set to 30 minutes, it may be determined that a result of LUT64 730 satisfies the preset condition.

The second calculator 120 may determine that the modified LUT (e.g., an n-th LUT) or an LUT (e.g., an (n-1)-th LUT) previous to the modified LUT is the final LUT according to a preset policy.

For example, when the LUT64 730 corresponds to a last modified LUT, the second calculator 120 may determine that the LUT64 730 is the final LUT.

In another example, the second calculator 120 may determine that an LUT63 720 previous to the LUT64 730 is the final LUT.

In yet another example, a difference between a charging time (e.g., 30.08 minutes) of the LUT64 730 and the preset time (e.g., 30 minutes) may be calculated to be 0.08 minutes, and a difference between a charging time (e.g., 29.98 minutes) of the LUT63 720 previous to the LUT64 730 and the preset time (e.g., 30 minutes) may be calculated to be 0.02 minutes. In this example, the second calculator 120 may determine that the LUT63 720 having a smaller difference is the final LUT.

In operation 650, the second calculator 120 may generate a charging path for the battery 130 based on the final LUT. The charging path may be a path in which each of the intervals of the fast charging interval is changed.

For example, a condition for changing from the first interval to the second interval in the charging path may be a charging limit condition for the first interval of the final LUT. For example, when the charging limit condition is an anode potential, and the anode potential of the battery 130 estimated while the battery 130 is charged with a first current (e.g., 7.92 A) reaches an anode potential limit (e.g., 0.062 V) for the first interval of the final LUT, the charging current may be changed from the first current to a second current (e.g., 7.57 A). In this way, the second calculator 120 may control charging (or fast charging) of the battery 130.

The second calculator 120 may store the final LUT in the second memory 121. The second calculator 120 may transmit the final LUT to the first calculator 110, and the first calculator 110 may store the final LUT in the first memory 111.

It is illustrated that the second calculator 120 updates the fast charging algorithm referring to FIGS. 6 and 7, but this is merely an example. According to an example, the first calculator 110 may perform some of the operations of updating the fast charging algorithm, and the second calculator 120 may perform the remaining operations.

The examples described with reference to FIGS. 6 and 7 may apply to an example in which the first calculator 110 may include the first battery model 161 and the second calculator 120 may include the second battery model 171. In addition, the description provided with reference to FIGS. 6 and 7 may apply to an example in which the first calculator 110 may not include the first battery model 161 and the second calculator 120 may include the second battery model 171.

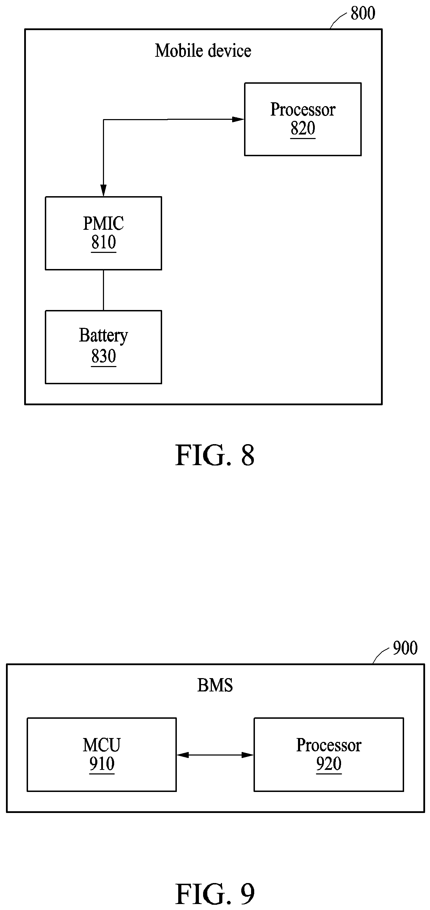

FIG. 8 illustrates an example of a mobile device.

Referring to FIG. 8, a mobile device 800 may include a PMIC (or a fuel-gauge IC (FGIC)) 810, a processor 820 (e.g., one or more processors), and a battery 830. The processor 820 may correspond to an application processor. The processor 820 may be or include, for example, a central processing unit (CPU), a processor core, a multi-core processor, a multiprocessor, an application-specific integrated circuit (ASIC), and/or a field-programmable gate array (FPGA). The mobile device 800 of FIG. 8 may be an example of the electronic apparatus 100 of FIGS. 1A and 1B.

The mobile device 800 may be or include, for example, a smartphone or a tablet personal computer (PC), but is not limited thereto.

The mobile device 800 may further include a display (e.g., the display 150 of FIG. 1), a sensor (e.g., the sensor 140 of FIG. 1), and the like.

The PMIC 810 may receive power from an external apparatus (e.g., a travel adapter (TA) or another mobile device) and charge the battery 830 based on the received power. The PMIC 810 may convert the power stored in the battery 830 into a voltage suitable for components (e.g., the processor 820, etc.) of the mobile device 800 and supply the converted power to the components of the mobile device 800.

The above-described first calculator 110 may be, include, or be included in the PMIC 810, and the second calculator 120 may be, include, or be included in the processor 820. In other words, the PMIC 810 may perform operations of the first calculator 110, and the processor 820 may perform operations of the second calculator 120.

The PMIC 810 may obtain sensing data of the battery 830 using the sensor, preprocess the obtained sensing data, and store the preprocessed sensing data in a first memory. The first memory may be positioned inside the PMIC 810. The PMIC 810 may determine first state information (e.g., SOC) of the battery 130 using the first battery model 161 and sensing data (or preprocessed sensing data) of the battery 830. The processor 820 may receive the sensing data stored in the first memory from the PMIC 810 and receive the first state information (e.g., SOC) of the battery 130. The processor 820 may control the display such that the determined first state information is displayed on the display.

The PMIC 810 may obtain measurement data of a voltage of the battery 830, store the measurement data in the first memory, and transmit the measurement data to the processor 820 when a transmission period is reached. The processor 820 may obtain estimation data of the voltage of the battery 830 using the second battery model 171, estimate an aging variation of the battery 830 based on the estimation data and the measurement data, and update an aging parameter of the second battery model 171 using the aging variation.

The processor 820 may receive information (e.g., the sensing data of the battery 830, etc.) required to update the first battery model 161 from the PMIC 810. The processor 820 may estimate (or determine) an aging state of the battery 830 using the second battery model 171 and the information (e.g., the received sensing data, etc.) received from the PMIC 810. The battery 830 may age with use, and as the battery 830 ages, the OCV, capacity, and internal resistance of the battery 830 may change. In order to reflect this change in the first battery model 161, the processor 820 may update parameters (e.g., an OCV parameter, a capacity parameter, and an internal resistance parameter) of the first battery model 161 based on the estimated aging state of the battery 830 and transmit the updated parameters to the PMIC 810. The PMIC 810 may apply the updated parameters to the first battery model 161. Accordingly, the PMIC 810 may determine the first state information (e.g., SOC) of the battery 830 in accordance with the estimated aging state of the battery 830 through the first battery model 161 to which the updated parameters are applied.

The processor 820 may store the updated aging parameter (or the estimated aging variation) in a second memory (e.g., the second memory 121 of FIG. 1A). When detecting that the mobile device 800 enters a power-off state, the processor 820 may transmit the updated aging parameter stored in the second memory to the PMIC 810. The PMIC 810 may store the updated aging parameter received from the processor 820 in the first memory.

When updating the aging parameter of the second battery model 171 (e.g., an electrochemical model), the processor 820 may apply the updated aging parameter to the second battery model 171. The processor 820 may generate basic simulation data for preset charging currents using the second battery model 171 to which the updated aging parameter is applied. The processor 820 may generate an initial LUT (e.g., the LUT 710 of FIG. 7) for the preset charging currents and preset battery voltage limits based on the basic simulation data. The processor 820 may generate a modified LUT by adjusting one or more of initial charging limit conditions of the initial LUT when the initial LUT fails to satisfy a preset condition. The processor 820 may determine that the modified LUT is the final LUT when the modified LUT satisfies the preset condition. The PMIC 810 may control charging of the battery 830 based on the determined final LUT.

The PMIC 810 may perform SOC estimation. More particularly, when an update period (e.g., an SOC update period or the transmission period of FIG. 3) is reached, the PMIC 810 may estimate a charging state of the battery 830 based on the sensing data stored in the first memory and transmit the estimated charging state to the processor 820. The processor 820 may control the display such that the received charging state is displayed on the display.

Instead of the processor 820, the PMIC 810 may update the aging parameter of the second battery model 171. The PMIC 810 may obtain the measurement data of the voltage of the battery 830, obtain the estimation data of the voltage of the battery 830 using the second battery model 171, and estimate the aging variation of the battery 830 using the estimation data and the measurement data. The PMIC 810 may update the aging parameter of the second battery model 171 using the estimated aging variation. The PMIC 810 may transmit the updated aging parameter to the processor 820. The PMIC 810 or the processor 820 may apply the updated aging parameter to the second battery model 171.

The mobile device 800 may execute a high-precision BMS algorithm using existing hardware (a PMIC and an AP). Accordingly, the mobile device 800 may execute the high-precision BMS algorithm without changing hardware, providing more accurate and various information to a user.

The above-described operations of the PMIC 810 may be implemented, for example, as control logic (or a controller) in the PMIC 810 executes firmware (or software or an application), but examples are not limited thereto. An operation between the PMIC 810 and the processor 820 may be implemented, for example, by linking the firmware (or the software or application) of the PMIC 810 and a kernel driver of the processor 820, but examples are not limited thereto.

The examples described with reference to FIGS. 1A to 7 may apply to the mobile device 800 of FIG. 8.

FIG. 9 illustrates an example of a battery management system (BMS).

Referring to FIG. 9, a BMS 900 may include a micro controller unit (MCU) 910 and a processor 920. The BMS 900 of FIG. 9 may be an example of the electronic apparatus 100 of FIG. 1.

The processor 920 may correspond to, for example, an application processor.

Instead of the MCU 910, the application processor may be used.

The above-described first calculator 110 may correspond to the MCU 910, and the second calculator 120 may correspond to the processor 920.

The BMS 900 may be applied to an energy storage device, an electric vehicle, and the like.

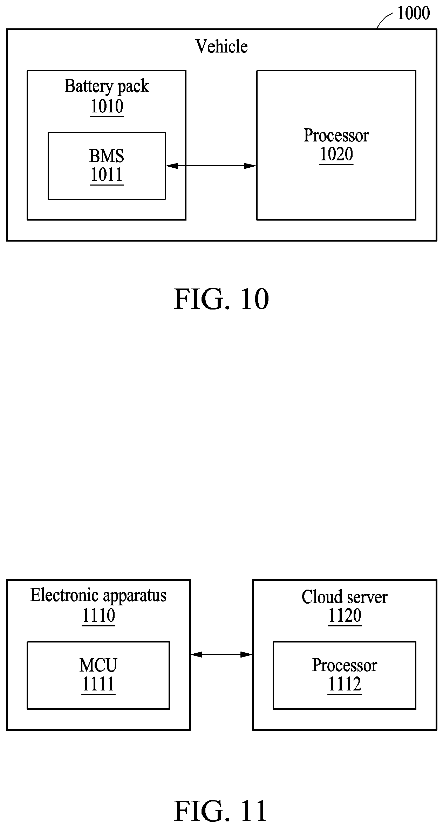

FIG. 10 illustrates an example of a vehicle.

Referring to FIG. 10, a vehicle 1000 may include a battery pack 1010 and a processor 1020. The battery pack 1010 may include a plurality of batteries and a BMS 1011.

The vehicle 1000 may use the battery pack 1010 as a power source. For example, the vehicle 1000 may include an electric vehicle, an autonomous vehicle, and the like.

The processor 1020 may correspond to, for example, an application processor, but examples are not limited thereto. The processor 1020 may generally control the vehicle 1000. The vehicle 1000 of FIG. 10 may be an example of the electronic apparatus 100 of FIG. 1.

The BMS 1011 may include an MCU. Unlike the BMS 900 of FIG. 9, the BMS 1011 of FIG. 10 may not include the processor 920.

The MCU in the BMS 1011 may correspond to the above-described first calculator 110, and the processor 1020 may correspond to the above-described second calculator 120.

In the example of FIG. 9, operations (e.g., sensing, preprocessing, SOC estimation, voltage error correction, updating of the first battery model 161, updating of an aging parameter of the second battery model 171, updating of a fast charging algorithm, fault prediction, life estimation, etc.) of the BMS 900 may be divided and performed by the plurality of computing components 910 and 920 in the BMS 900. On the other hand, in the example of FIG. 10, some of the operations of the BMS 1011 may be performed by the processor 1020 in the vehicle 1000.

The MCU in the BMS 1011 may obtain sensing data of each battery using a sensor of each battery, preprocess the obtained sensing data of each battery, and store the preprocessed sensing data of each battery in a first memory of the BMS 1011. The MCU in the BMS 1011 may determine first state information (e.g., an SOC) of each battery using each of the battery models and the sensing data of each battery. Each of the battery models may correspond to the first battery model 161, and each of the battery models may correspond to each of the batteries of the battery pack 1010. The MCU in the BMS 1011 may determine an SOC of the battery pack 1010 using the first state information (e.g., SOC) of each battery and transmit the SOC of the battery pack 1010 to the processor 1020. The processor 1020 may display the SOC of the battery pack 1010 on a display of the vehicle 1000.

The processor 1020 may receive the sensing data stored in the first memory from the MCU in the BMS 1011 and estimate an aging state of each battery using the second battery model 171 and the received sensing data. The processor 1020 may update the parameters of each of first battery models based on the estimated aging state of each battery. The processor 1112 may transmit the updated parameters of each of the first battery models to the MCU in the BMS 1011. The MCU in the BMS 1011 may reflect (or apply) the updated parameters of each of the first battery models in each of the first battery models.

The examples described with reference to FIGS. 1A to 9 may apply to the vehicle of FIG. 10, and thus, a detailed description thereof is omitted.

FIG. 11 illustrates an example of an electronic apparatus and a cloud server.

Referring to FIG. 11, the electronic apparatus 1110 may communicate with a cloud server 1120.

The electronic apparatus 1110 may correspond to, for example, the electronic apparatus 100, the mobile device 800, the BMS 900, and/or the vehicle 1000.

The electronic apparatus 1110 may include the MCU 1111. According to implementation, a processor (e.g., an application processor) may be used instead of the MCU 1111.

The MCU 1111 may correspond to the above-described first calculator 110, and the processor 1112 in the cloud server 1120 may correspond to the above-described second calculator 120.

The MCU 1111 may obtain sensing data of a battery of the electronic apparatus 1110 using a sensor (e.g., the sensor 140 of FIG. 1), preprocess the obtained sensing data, and store the preprocessed sensing data in a first memory of the electronic apparatus 1110. The MCU 1111 may determine the first state information (e.g., SOC) of the battery using the first battery model 161 and the obtained sensing data (or preprocessed sensing data). The MCU 1111 may control a display of the electronic apparatus 1110 such that the first state information (e.g., SOC) is displayed on the display of the electronic apparatus 1110. The processor 1112 may receive the sensing data stored in the first memory from the MCU 1111 and determine second state information of the battery of the electronic apparatus 1110 using the second battery model 171 and the received sensing data. The processor 1112 may transmit the determined second state information to the MCU 1111. The processor 1112 may estimate the aging state of the battery of the electronic apparatus 1110 using the sensing data received from the MCU 1111 and the second battery model 171. The processor 1112 may update the parameters of the first battery model 161 based on the estimated aging state and transmit the updated parameters to the electronic apparatus 1110. The MCU 1111 may reflect (or apply) the updated parameters in the first battery model 161.

The examples described with reference to FIGS. 1A to 10 may apply to FIG. 11, and thus a detailed description is omitted.

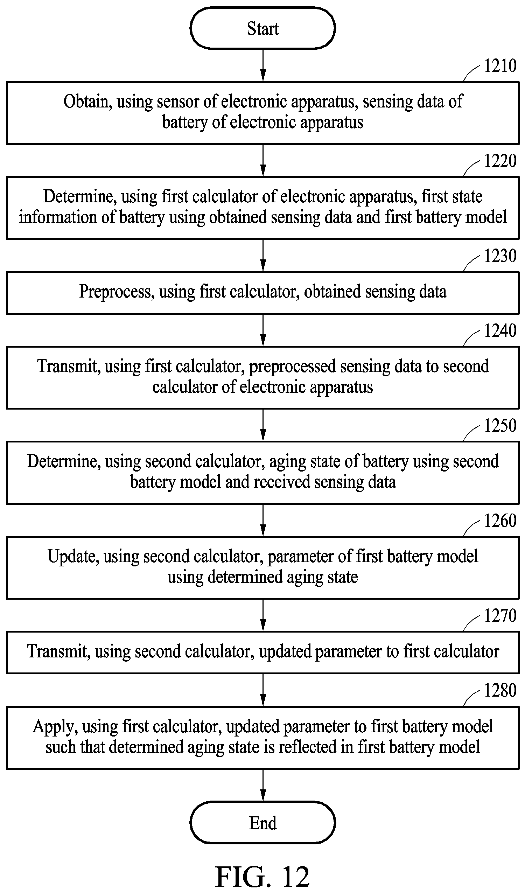

FIG. 12 illustrates an example of an operating method of an electronic apparatus.

Referring to FIG. 12, in operation 1210, the sensor 140 of the electronic apparatus 100 may obtain sensing data of the battery 130 of the electronic apparatus 100.

In operation 1220, the first calculator 110 of the electronic apparatus 100 may determine first state information of the battery 130 using the obtained sensing data and the first battery model 161.

In operation 1230, the first calculator 110 may preprocess the obtained sensing data.

In operation 1240, the first calculator 110 may transmit the preprocessed sensing data to the second calculator 120 of the electronic apparatus 100.

In operation 1250, the second calculator 120 may determine an aging state of the battery 130 using the second battery model 171 and the received sensing data.

In operation 1260, the second calculator 120 may update a parameter (e.g., any one or any combination of any two or more of an OCV parameter, a capacity parameter, or an internal resistance parameter) of the first battery model 161 using the determined aging state.

In operation 1270, the second calculator 120 may transmit the updated parameter to the first calculator 110.

In operation 1280, the first calculator 110 may apply the updated parameter to the first battery model 161 such that the determined aging state is reflected in the first battery model 161.

The first calculator 110 may not include the first battery model 161, and the second calculator 120 may include the second battery model 171.

For example, the first calculator 110 may obtain measurement data of a voltage of the battery 130, store the measurement data in the first memory 111, and transmit the measurement data to the second calculator 120 in response to a transmission period being reached. The second calculator 120 may obtain estimation data of the voltage of the battery 130 using a battery model (e.g., the second battery model 171), estimate an aging variation of the battery 130 based on the measurement data and the estimation data, and update an aging parameter of the battery model (e.g., the second battery model 171) using the aging variation.

The second calculator 120 may store the updated aging parameter in the second memory 121 and transmit the updated aging parameter stored in the second memory 121 to the first calculator 110 in response to detecting that the electronic apparatus 100 enters a power-off state. The first calculator 110 may store the updated aging parameter received from the second calculator 120 in the first memory 111.

When updating the aging parameter of the battery model (e.g., the second battery model 171), the second calculator 120 may apply the updated aging parameter to the battery model (e.g., the second battery model 171). The second calculator 120 may generate a plurality of pieces of basic simulation data for each of the preset charging currents using the battery model to which the updated aging parameter is applied. The second calculator 120 may generate an LUT for charging currents and preset battery voltage limits based on the plurality of pieces of basic simulation data. The second calculator 120 may generate a modified LUT by adjusting one or more initial charging limit conditions of the initial LUT in response to the initial LUT failing to satisfy a preset condition. When the modified LUT satisfies the preset condition, the second calculator 120 may determine the final LUT based on the modified LUT and control charging of the battery 130 based on the determined final LUT.

The second calculator 120 may transmit the determined final LUT to the first calculator 110, and the first calculator 110 may store the received final LUT in the first memory 111.

The examples described with reference to FIGS. 1A to 11 may apply to FIG. 12, and thus a detailed description is omitted.

The electronic apparatuses, first calculators, second calculators, batteries, first memories, second memories, mobile devices, PMICs, processors, BMSs, MCUs, vehicles, battery packs, cloud servers, electronic apparatus 100, first calculator 110, second calculator 120, battery 130, first memory 111, second memory 121, mobile device 800, PMIC 810, processor 820, battery 830, BMS 900, MCU 910, processor 920, vehicle 1000, battery pack 1010, processor 1020, BMS 1011, electronic apparatus 1110, cloud server 1120, MCU 1111, processor 1112, and other apparatuses, devices, units, modules, and components disclosed and described herein with respect to FIGS. 1-11 are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in FIGS. 1-11 that perform the operations described in this application are performed by computing hardware, for example, by one or more processors or computers, implemented as described above implementing instructions or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. In one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks, and any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims. The examples described herein are to be considered in a descriptive sense only, and not for purposes of limitation. Descriptions of features or aspects in each example are to be considered as being applicable to similar features or aspects in other examples. Suitable results may be achieved if the described techniques are performed in a different order.

Therefore, in view of the above and all drawing disclosures, the scope of the invention is defined by the enclosed claims.

**Claims**

1. An electronic apparatus (100) comprising:

 a battery (130);
 a first calculator (110) configured to obtain sensing data of the battery (130) using a sensor (140), determine first state information of the battery (130) using the obtained sensing data and a first battery model, and preprocess the obtained sensing data; and
 a second calculator (120) configured to receive the preprocessed sensing data from the first calculator (110), determine an aging state of the battery (130) using a second battery model and the received sensing data, update a parameter of the first battery model based on the determined aging state, and transmit the updated parameter to the first calculator (110),

wherein, in response to receiving the updated parameter from the second calculator (120), the first calculator (110) is configured to apply the updated parameter to the first battery model such that the determined aging state is reflected in the first battery model.

2. The electronic apparatus of claim 1, wherein
   the first calculator is configured to:

   for the preprocessing of the obtained sensing data, obtain measurement data of a voltage of the battery;
   for the storing of the preprocessed sensing data, store the measurement data in the first memory of the first calculator; and
   transmit the measurement data to the second calculator in response to a transmission period being reached, and the second calculator is configured to, for the determining of the state information, obtain estimation data of a voltage of the battery using the second battery model, estimate an aging variation of the battery based on the estimation data and the measurement data, and update an aging parameter of the second battery model using the aging variation.

3. The electronic apparatus of claim 2, wherein

   the second calculator is configured to store the updated aging parameter of the second battery model in a second memory of the second calculator and transmit the updated aging parameter stored in the second memory to the first calculator in response to detecting that the electronic apparatus enters a power-off state, and
   the first calculator is configured to store the updated aging parameter received from the second calculator in the first memory of the first calculator, or
   for the estimating of the aging variation, the second calculator is configured to determine a resistance increase using a variation in the estimation data, a variation in the measurement data, and a current variation; and determine, as the aging variation, a variation in an anodic solid electrolyte interphase, SEI, resistance based on the resistance increase, or
   wherein the aging parameter comprises any one or any combination of any two or more of an anodic solid electrolyte interphase, SEI, resistance, a capacity of a cathode active material, and an electrode balance shift of the battery.

4. The electronic apparatus of one of claims 2 to 3, wherein the second calculator is configured to apply, in response to updating the aging parameter of the second battery model, the updated aging parameter of the second battery model to the second battery model, generate basic simulation data for preset charging currents using the second battery model to which the updated aging parameter is applied, generate an initial look-up table, LUT, for the charging currents and preset battery voltage limits based on the basic simulation data, generate a modified LUT by adjusting one or more initial charging limit conditions of the initial LUT in response to the initial LUT failing to satisfy a preset condition, determine a final LUT based on the modified LUT in response to the modified LUT satisfying the preset condition, and control charging of the battery based on the determined final LUT, and
   wherein the second calculator is further configured to transmit the determined final LUT to the first calculator, and the first calculator is configured to store the received determined final LUT in the first memory of the first calculator.

5. The electronic apparatus of one of claims 1 to 4, wherein

   the first calculator is configured to transmit the determined first state information to the second calculator, and
   the second calculator is configured to control a display such that the received first state information is displayed on the display.

6. The electronic apparatus of one of claims 1 to 5, wherein the first state information comprises state of charge, SOC, information of the battery.

7. The electronic apparatus of one of claims 1 to 6, wherein

   the first calculator is comprised in a power management integrated circuit, and
   the second calculator is comprised in an application processor.

8. An operating method of an electronic apparatus (100), the operating method comprising:

obtaining, using a first calculator (110) of the electronic apparatus (100), sensing data of a battery (130) using a sensor (140);

preprocessing, using the first calculator (110), the obtained sensing data, and storing the preprocessed sensing data in a first memory (111);

receiving, using a second calculator (120) of the electronic apparatus (100), the sensing data stored in the first memory (111) from the first calculator (110);

determining, using the second calculator (120), state information of the battery (130) using a battery model and the received sensing data; and

controlling, using the second calculator (120), a display (150) such that the determined state information is displayed on the display (150),

obtaining, using the second calculator (120), estimation data of a voltage of the battery (130) using the battery model;

estimating, using the second calculator (120), an aging variation of the battery (130) based on the estimation data and measurement data of the voltage of the battery; and

updating, using the second calculator (120), an aging parameter of the battery model using the aging variation.

9. The operating method of claim 8 further comprising:

for preprocessing of the obtained sensing data, obtaining, using a power management integrated circuit, the measurement data of the voltage of the battery;

for storing of the preprocessed sensing data, storing, using the power management integrated circuit, the measurement data in the first memory; and

transmitting, using the power management integrated circuit, the measurement data to a processor of the electronic apparatus in response to a transmission period being reached.

10. The operating method of claim 8 further comprising:

storing, using the second calculator, the updated aging parameter in a second memory of the second calculator;

transmitting, using the second calculator, the updated aging parameter stored in the second memory to the first calculator in response to detecting that the electronic apparatus enters a power-off state, and

storing using the first calculator, the updated aging parameter received from the second calculator in the first memory, or

for estimating of the aging variation, the method further comprises:

determining, using the processor, a resistance increase using a variation in the estimation data, a variation in the measurement data, and a current variation; and

determining, using the processor, as the aging variation, a variation in an anodic solid electrolyte interphase, SEI, resistance based on the resistance increase.

11. The operating method of claim 8, wherein the aging parameter comprises any one or any combination of any two or more of an anodic solid electrolyte interphase, SEI, resistance, a capacity of a cathode active material, and an electrode balance shift of the battery.

12. The operating method of one of claims 8 to 11 further comprising, using the second calculator, for:

applying in response to updating the aging parameter of the battery model, the updated aging parameter to the battery model;

generating a plurality of pieces of basic simulation data for each of preset charging currents using the battery model to which the updated aging parameter is applied;

generating an initial look-up table, LUT, for the charging currents and preset battery voltage limits based on the plurality of pieces of basic simulation data;

generating a modified LUT by adjusting one or more initial charging limit conditions of the initial LUT in response to the initial LUT failing to satisfy a preset condition;

determining a final LUT based on the modified LUT in response to the modified LUT satisfying the preset condition; and

controlling charging of the battery based on the determined final LUT.

13. The operating method of claim 12 further comprising:

transmitting, using the second calculator, the determined final LUT to the first calculator, and
storing, using the first calculator, the received determined final LUT in the first memory.

14. The operating method of one of claims 8 to 13 further comprising:
in response to an update period being reached, estimating, using the first calculator, a charging state of the battery based on the sensing data stored in the first memory and transmitting the estimated charging state to the second calculator.

**Patentansprüche**

1. Elektronische Vorrichtung (100), aufweisend:

    eine Batterie (130);
    einen ersten Kalkulator (110), der so konfiguriert ist, dass er unter Verwendung eines Sensors (140) Erfassungsdaten der Batterie (130) ermittelt, unter Verwendung der ermittelten Erfassungsdaten und eines ersten Batteriemodells erste Zustandsinformationen der Batterie (130) ermittelt und die ermittelten Erfassungsdaten vorverarbeitet; und
    einen zweiten Kalkulator (120), der so konfiguriert ist, dass er die vorverarbeiteten Erfassungsdaten von dem ersten Kalkulator (110) empfängt, einen Alterungszustand der Batterie (130) unter Verwendung eines zweiten Batteriemodells und der empfangenen Erfassungsdaten bestimmt, einen Parameter des ersten Batteriemodells basierend auf dem ermittelten Alterungszustand aktualisiert und den aktualisierten Parameter an den ersten Kalkulator (110) überträgt,
    wobei der erste Kalkulator (110) so konfiguriert ist, dass er, als Reaktion auf den Empfang des aktualisierten Parameters von dem zweiten Kalkulator (120) den aktualisierten Parameter auf das erste Batteriemodell anwendet, sodass der bestimmte Alterungszustand in dem ersten Batteriemodell widergespiegelt wird.

2. Elektronische Vorrichtung nach Anspruch 1, wobei
der erste Kalkulator so konfiguriert ist, dass er:

    für die Vorverarbeitung der ermittelten Erfassungsdaten Messdaten einer Spannung der Batterie ermittelt;
    für die Speicherung der vorverarbeiteten Erfassungsdaten die Messdaten in dem ersten Speicher des ersten Kalkulators speichert; und
    als Reaktion darauf, dass eine Übertragungsperiode erreicht ist, die Messdaten an den zweiten Kalkulator überträgt, und
    der zweite Kalkulator so konfiguriert ist, dass er für die Bestimmung der Zustandsinformationen Schätzdaten einer Spannung der Batterie unter Verwendung des zweiten Batteriemodells ermittelt, einen Alterungsverlauf der Batterie basierend auf den Schätzdaten und den Messdaten schätzt und einen Alterungsparameter des zweiten Batteriemodells unter Verwendung des Alterungsverlauf aktualisiert.

3. Elektronische Vorrichtung nach Anspruch 2, wobei

    der zweite Kalkulator so konfiguriert ist, dass er den aktualisierten Alterungsparameter des zweiten Batteriemodells in einem zweiten Speicher des zweiten Kalkulators speichert und den in dem zweiten Speicher gespeicherten aktualisierten Alterungsparameter an den ersten Kalkulator überträgt als Reaktion darauf, dass die elektronische Vorrichtung in einen ausgeschalteten Zustand übergeht, und
    der erste Kalkulator so konfiguriert ist, dass er den von dem zweiten Kalkulator empfangenen aktualisierten Alterungsparameter in dem ersten Speicher des ersten Kalkulators speichert, oder
    für die Schätzung des Alterungsverlaufs der zweite Kalkulator so konfiguriert ist, dass er einen Widerstandsanstieg unter Verwendung einer Abweichung der Schätzdaten, einer Abweichung der Messdaten und einer Stromabweichung bestimmt; und als den Alterungsverlauf eine Abweichung eines Widerstands der anodischen Festelektrolyt-Zwischenphase (SEI) basierend auf dem Widerstandsanstieg bestimmt, oder
    wobei der Alterungsparameter jede/n von oder eine beliebige Kombination aus beliebigen zwei oder mehr von einem Widerstand der anodischen Festelektrolyt-Zwischenphase (SEI), einer Kapazität eines aktiven Kathodenmaterials und einer Verschiebung des Elektrodengleichgewichts der Batterie aufweist.

4. Elektronische Vorrichtung nach einem der Ansprüche 2 bis 3, wobei der zweite Kalkulator so konfiguriert ist, dass er als Reaktion auf die Aktualisierung des Alterungsparameters des zweiten Batteriemodells den aktualisierten Alterungsparameter des zweiten Batteriemodells auf das zweite Batteriemodell anwendet, grundlegende Simulationsdaten für voreingestellte Ladeströme unter Verwendung des zweiten Batteriemodells, auf das der aktualisierte Alterungsparameter angewendet wird, erzeugt, eine anfängliche Lookup-Tabelle (LUT) für die Grenzwerte der Ladeströme und der voreingestellten Batteriespannung basierend auf den grundlegenden Simulationsdaten erzeugt, eine modifizierte LUT erzeugt, indem eine oder mehrere anfängliche Ladegrenzbedingungen der anfänglichen LUT als Reaktion darauf angepasst werden, dass die anfängliche LUT eine voreingestellte Bedingung nicht erfüllt, eine endgültige LUT basierend auf der modifizierten LUT als Reaktion darauf bestimmt, dass die modifizierte LUT die voreingestellte Bedingung erfüllt, und das Laden der Batterie basierend auf der bestimmten endgültigen LUT steuert, und

wobei der zweite Kalkulator ferner so konfiguriert ist, dass er die bestimmte endgültige LUT an den ersten Kalkulator überträgt, und der erste Kalkulator so konfiguriert ist, dass er die empfangene bestimmte endgültige LUT in dem ersten Speicher des ersten Kalkulators speichert.

5. Elektronische Vorrichtung nach einem der Ansprüche 1 bis 4, wobei

der erste Kalkulator so konfiguriert ist, dass er die bestimmte erste Zustandsinformation an den zweiten Kalkulator überträgt, und
der zweite Kalkulator so konfiguriert ist, dass er eine Anzeige so steuert, dass die empfangene erste Zustandsinformation auf der Anzeige angezeigt wird.

6. Elektronische Vorrichtung nach einem der Ansprüche 1 bis 5, wobei die erste Zustandsinformation Informationen zum Ladezustand (SOC) der Batterie aufweist.

7. Elektronische Vorrichtung nach einem der Ansprüche 1 bis 6, wobei

der erste Kalkulator in einer integrierten Leistungsverwaltungs-Schaltung enthalten ist und
der zweite Kalkulator in einem Anwendungsprozessor enthalten ist.

8. Betriebsverfahren für eine elektronische Vorrichtung (100), wobei das Betriebsverfahren umfasst:

Ermitteln, unter Verwendung eines ersten Kalkulators (110) der elektronischen Vorrichtung (100), von Erfassungsdaten einer Batterie (130) unter Verwendung eines Sensors (140);
Vorverarbeiten, unter Verwendung des ersten Kalkulators (110), der ermittelten Erfassungsdaten und Speichern der vorverarbeiteten Erfassungsdaten in einem ersten Speicher (111);
Empfangen, unter Verwendung eines zweiten Kalkulators (120) der elektronischen Vorrichtung (100), der in dem ersten Speicher (111) gespeicherten Erfassungsdaten von dem ersten Kalkulator (110);
Bestimmen, unter Verwendung des zweiten Kalkulators (120), von Zustandsinformationen der Batterie (130) unter Verwendung eines Batteriemodells und der empfangenen Erfassungsdaten; und
Steuern, unter Verwendung des zweiten Kalkulators (120), einer Anzeige (150), sodass die bestimmten Zustandsinformationen auf der Anzeige (150) angezeigt werden;
Ermitteln, unter Verwendung des zweiten Kalkulators (120), von Schätzdaten einer Spannung der Batterie (130) unter Verwendung des Batteriemodells;
Schätzen, unter Verwendung des zweiten Kalkulators (120), eines Alterungsverlaufs der Batterie (130) basierend auf den Schätzdaten und der Messdaten der Spannung der Batterie; und
Aktualisieren, unter Verwendung des zweiten Kalkulators (120), eines Alterungsparameters des Batteriemodells unter Verwendung des Alterungsverlaufs.

9. Betriebsverfahren nach Anspruch 8, das ferner umfasst:

zum Vorverarbeiten der ermittelten Erfassungsdaten, Ermitteln der Messdaten der Batteriespannung unter Verwendung einer integrierten Leistungsverwaltungs-Schaltung;
zum Speichern der vorverarbeiteten Erfassungsdaten, Speichern der Messdaten in dem ersten Speicher unter Verwendung der integrierten Leistungsverwaltungs-Schaltung; und
Übertragen der Messdaten an einen Prozessor der elektronischen Vorrichtung unter Verwendung der integrierten Leistungsverwaltungs-Schaltung als Reaktion darauf, dass eine Übertragungsperiode erreicht ist.

10. Betriebsverfahren nach Anspruch 8, ferner umfassend:

Speichern des aktualisierten Alterungsparameters in einem zweiten Speicher des zweiten Kalkulators unter Verwendung des zweiten Kalkulators;

Übertragen, unter Verwendung des zweiten Kalkulators, des in dem zweiten Speicher gespeicherten aktualisierten Alterungsparameters an den ersten Kalkulator als Reaktion darauf, dass erfasst wird, dass die elektronische Vorrichtung in einen ausgeschalteten Zustand übergeht, und

Speichern, unter Verwendung des ersten Kalkulators, des von dem zweiten Kalkulator empfangenen aktualisierten Alterungsparameters in dem ersten Speicher, oder

wobei zum Schätzen des Alterungsverlaufs das Verfahren ferner umfasst:

Bestimmen, unter Verwendung des Prozessors, eines Widerstandsanstiegs unter Verwendung einer Abweichung der Schätzdaten, einer Abweichung der Messdaten und einer Stromabweichung; und

Bestimmen, als der Alterungsverlauf, einer Abweichung eines Widerstands der anodischen Festelektrolyt-Zwischenphase (SEI) basierend auf dem Widerstandsanstieg unter Verwendung des Prozessors.

11. Betriebsverfahren nach Anspruch 8, wobei der Alterungsparameter jede/n von oder eine beliebige Kombination aus beliebigen zwei oder mehr von einem Widerstand der anodischen Festelektrolyt-Zwischenphase (SEI), einer Kapazität eines aktiven Kathodenmaterials und einer Verschiebung des Elektrodengleichgewichts der Batterie aufweist.

12. Betriebsverfahren nach einem der Ansprüche 8 bis 11, das ferner unter Verwendung des zweiten Kalkulators umfasst:

Anwenden des aktualisierten Alterungsparameters auf das Batteriemodell als Reaktion darauf, dass der Alterungsparameters des Batteriemodells aktualisiert ist;

Erzeugen einer Vielzahl von grundlegenden Simulationsdaten für jeden von den voreingestellten Ladeströmen unter Verwendung des Batteriemodells, auf das der aktualisierte Alterungsparameter angewendet wird;

Erzeugen einer anfänglichen Lookup-Tabelle (LUT) für die Grenzwerte der Ladeströme und voreingestellten Batteriespannung basierend auf der Vielzahl von einzelnen grundlegenden Simulationsdaten;

Erzeugen einer modifizierten LUT durch Anpassen von einer oder mehreren anfänglichen Ladegrenzebedingungen der anfänglichen LUT als Reaktion darauf, dass die anfängliche LUT eine voreingestellte Bedingung nicht erfüllt;

Bestimmen einer endgültigen LUT basierend auf der modifizierten LUT als Reaktion darauf, dass die modifizierte LUT die voreingestellte Bedingung erfüllt; und

Steuern des Ladevorgangs der Batterie basierend auf der bestimmten endgültigen LUT.

13. Betriebsverfahren nach Anspruch 12, ferner umfassend:

Übertragen, unter Verwendung des zweiten Kalkulators, der bestimmten endgültigen LUT an den ersten Kalkulator, und

Speichern, unter Verwendung des ersten Kalkulators, der empfangenen bestimmten endgültigen LUT in dem ersten Speicher.

14. Betriebsverfahren nach einem der Ansprüche 8 bis 13, ferner umfassend:
als Reaktion darauf, dass eine Aktualisierungsperiode erreicht ist, Schätzen eines Ladezustands der Batterie unter Verwendung des ersten Kalkulators basierend auf den in dem ersten Speicher gespeicherten Erfassungsdaten und Übertragen des geschätzten Ladezustands an den zweiten Kalkulator.

**Revendications**

1. Appareil électronique (100) comprenant :

une batterie (130) ;

un premier calculateur (110) configuré pour obtenir des données de détection de la batterie (130) au moyen d'un capteur (140), déterminer une première information d'état de la batterie (130) à l'aide des données de détection obtenues et d'un premier modèle de batterie, et prétraiter les données de détection obtenues ; et

un deuxième calculateur (120) configuré pour recevoir les données de détection prétraitées en provenance du premier calculateur (110), déterminer un état de vieillissement de la batterie (130) à l'aide d'un deuxième modèle de batterie et des données de détection reçues, actualiser un paramètre du premier modèle de batterie sur la base de l'état de vieillissement déterminé, et transmettre le paramètre actualisé au premier calculateur (110), dans lequel, en réponse à la réception du paramètre actualisé en provenance du deuxième calculateur (120), le premier calculateur (110) est configuré pour appliquer le paramètre actualisé au premier modèle de batterie de sorte que l'état de vieillissement déterminé soit reflété dans le premier modèle de batterie.

2. Appareil électronique selon la revendication 1, dans lequel
le premier calculateur est configuré pour :

pour le prétraitement des données de détection obtenues, obtenir des données de mesure d'une tension de la batterie ;
pour le stockage des données de détection prétraitées, stocker les données de mesure dans la première mémoire du premier calculateur ; et
transmettre les données de mesure au deuxième calculateur en réponse à l'atteinte d'une période de transmission, et
le deuxième calculateur est configuré pour, pour la détermination de l'information d'état, obtenir des données d'estimation d'une tension de la batterie à l'aide du deuxième modèle de batterie, estimer une variation de vieillissement de la batterie sur la base des données d'estimation et des données de mesure, et actualiser un paramètre de vieillissement du deuxième modèle de batterie à l'aide de la variation de vieillissement.

3. Appareil électronique selon la revendication 2, dans lequel

le deuxième calculateur est configuré pour stocker le paramètre de vieillissement actualisé du deuxième modèle de batterie dans une deuxième mémoire du deuxième calculateur et transmettre le paramètre de vieillissement actualisé stocké dans la deuxième mémoire au premier calculateur en réponse à la détection du fait que l'appareil électronique entre dans un état hors tension, et
le premier calculateur est configuré pour stocker le paramètre de vieillissement actualisé reçu en provenance du deuxième calculateur dans la première mémoire du premier calculateur, ou
pour l'estimation de la variation de vieillissement, le deuxième calculateur est configuré pour déterminer une augmentation de résistance à l'aide d'une variation des données d'estimation, d'une variation des données de mesure et d'une variation de courant ; et déterminer, en tant que variation de vieillissement, une variation d'une résistance d'interphase d'électrolyte solide anodique sur la base de l'augmentation de résistance, ou
dans lequel le paramètre de vieillissement comprend l'un quelconque, ou toute combinaison de deux éléments ou plus, parmi une résistance d'interphase d'électrolyte solide anodique, une capacité d'un matériau actif de cathode, et un décalage d'équilibre d'électrode de la batterie.

4. Appareil électronique selon l'une des revendications 2 à 3, dans lequel le deuxième calculateur est configuré pour appliquer, en réponse à l'actualisation du paramètre de vieillissement du deuxième modèle de batterie, le paramètre de vieillissement actualisé du deuxième modèle de batterie au deuxième modèle de batterie, générer des données de simulation de base pour des courants de charge prédéfinis à l'aide du deuxième modèle de batterie auquel le paramètre de vieillissement actualisé est appliqué, générer une table de correspondance initiale pour les courants de charge et des limites de tension de batterie prédéfinies sur la base des données de simulation de base, générer une table de correspondance modifiée en ajustant une ou plusieurs conditions initiales de limitation de charge de la table de correspondance initiale en réponse au fait que la table de correspondance initiale ne satisfait pas à une condition prédéfinie, déterminer une table de correspondance finale sur la base de la table de correspondance modifiée en réponse au fait que la table de correspondance modifiée satisfait à la condition prédéfinie, et commander une charge de la batterie sur la base de la table de correspondance finale déterminée, et
dans lequel le deuxième calculateur est en outre configuré pour transmettre la table de correspondance finale déterminée au premier calculateur, et le premier calculateur est configuré pour stocker la table de correspondance finale déterminée reçue dans la première mémoire du premier calculateur.

5. Appareil électronique selon l'une des revendications 1 à 4, dans lequel

le premier calculateur est configuré pour transmettre la première information d'état déterminée au deuxième calculateur, et
le deuxième calculateur est configuré pour commander un afficheur de sorte que la première information d'état reçue soit affichée sur l'afficheur.

6. Appareil électronique selon l'une des revendications 1 à 5, dans lequel la première information d'état comprend une information d'état de charge de la batterie.

7. Appareil électronique selon l'une des revendications 1 à 6, dans lequel
le premier calculateur est compris dans un circuit intégré de gestion d'alimentation, et le deuxième calculateur est compris dans un processeur d'application.

8. Procédé de fonctionnement d'un appareil électronique (100), le procédé de fonctionnement comprenant :

l'obtention, au moyen d'un premier calculateur (110) de l'appareil électronique (100), de données de détection d'une batterie (130) au moyen d'un capteur (140) ;
le prétraitement, au moyen du premier calculateur (110), des données de détection obtenues, et le stockage des données de détection prétraitées dans une première mémoire (111) ;
la réception, au moyen d'un deuxième calculateur (120) de l'appareil électronique (100), des données de détection stockées dans la première mémoire (111) en provenance du premier calculateur (110) ;
la détermination, au moyen du deuxième calculateur (120), d'une information d'état de la batterie (130) à l'aide d'un modèle de batterie et des données de détection reçues ; et
la commande, au moyen du deuxième calculateur (120), d'un afficheur (150) de sorte que l'information d'état déterminée soit affichée sur l'afficheur (150),
l'obtention, au moyen du deuxième calculateur (120), de données d'estimation d'une tension de la batterie (130) à l'aide du modèle de batterie ;
l'estimation, au moyen du deuxième calculateur (120), d'une variation de vieillissement de la batterie (130) sur la base des données d'estimation et de données de mesure de la tension de la batterie ; et
l'actualisation, au moyen du deuxième calculateur (120), d'un paramètre de vieillissement du modèle de batterie à l'aide de la variation de vieillissement.

9. Procédé de fonctionnement selon la revendication 8, comprenant en outre :

pour le prétraitement des données de détection obtenues, l'obtention, au moyen d'un circuit intégré de gestion d'alimentation, des données de mesure de la tension de la batterie ;
pour le stockage des données de détection prétraitées, le stockage, au moyen du circuit intégré de gestion d'alimentation, des données de mesure dans la première mémoire ; et
la transmission, au moyen du circuit intégré de gestion d'alimentation, des données de mesure à un processeur de l'appareil électronique en réponse à l'atteinte d'une période de transmission.

10. Procédé de fonctionnement selon la revendication 8, comprenant en outre :

le stockage, au moyen du deuxième calculateur, du paramètre de vieillissement actualisé dans une deuxième mémoire du deuxième calculateur ;
la transmission, au moyen du deuxième calculateur, du paramètre de vieillissement actualisé stocké dans la deuxième mémoire au premier calculateur en réponse à la détection du fait que l'appareil électronique entre dans un état hors tension, et
le stockage, au moyen du premier calculateur, du paramètre de vieillissement actualisé reçu en provenance du deuxième calculateur dans la première mémoire, ou
pour l'estimation de la variation de vieillissement, le procédé comprend en outre :

la détermination, au moyen du processeur, d'une augmentation de résistance à l'aide d'une variation des données d'estimation, d'une variation des données de mesure et d'une variation de courant ; et
la détermination, au moyen du processeur, en tant que variation de vieillissement, d'une variation d'une résistance d'interphase d'électrolyte solide anodique sur la base de l'augmentation de résistance.

11. Procédé de fonctionnement selon la revendication 8, dans lequel le paramètre de vieillissement comprend l'un quelconque, ou toute combinaison de deux éléments ou plus, parmi une résistance d'interphase d'électrolyte solide anodique, une capacité d'un matériau actif de cathode, et un décalage d'équilibre d'électrode de la batterie.

12. Procédé de fonctionnement selon l'une des revendications 8 à 11, comprenant en outre, au moyen du deuxième calculateur :

l'application, en réponse à l'actualisation du paramètre de vieillissement du modèle de batterie, du paramètre de vieillissement actualisé au modèle de batterie ;

la génération d'une pluralité de jeux de données de simulation de base pour chacun de courants de charge prédéfinis à l'aide du modèle de batterie auquel le paramètre de vieillissement actualisé est appliqué ;

la génération d'une table de correspondance initiale pour les courants de charge et des limites de tension de batterie prédéfinies sur la base de la pluralité de jeux de données de simulation de base ;

la génération d'une table de correspondance modifiée en ajustant une ou plusieurs conditions initiales de limitation de charge de la table de correspondance initiale en réponse au fait que la table de correspondance initiale ne satisfait pas à une condition prédéfinie ;

la détermination d'une table de correspondance finale sur la base de la table de correspondance modifiée en réponse au fait que la table de correspondance modifiée satisfait à la condition prédéfinie ; et

la commande d'une charge de la batterie sur la base de la table de correspondance finale déterminée.

13. Procédé de fonctionnement selon la revendication 12, comprenant en outre :

la transmission, au moyen du deuxième calculateur, de la table de correspondance finale déterminée au premier calculateur, et

le stockage, au moyen du premier calculateur, de la table de correspondance finale déterminée reçue dans la première mémoire.

14. Procédé de fonctionnement selon l'une des revendications 8 à 13, comprenant en outre :

en réponse à l'atteinte d'une période de mise à jour, l'estimation, au moyen du premier calculateur, d'un état de charge de la batterie sur la base des données de détection stockées dans la première mémoire et

la transmission de l'état de charge estimé au deuxième calculateur.

100

110

120

| First calculator |
| --- |
| First memory<br>111 |

| Second calculator |
| --- |
| Second memory<br>121 |

| Sensor<br>140 |
| --- |

| Display<br>150 |
| --- |

| Battery<br>130 |
| --- |

# FIG. 1A

110

First calculator

First battery model
161

120

Second calculator

Second battery model
171

Sensor
140

Display
150

Battery
130

FIG. 1B

110 ──
┌─────────────────────────┐
│    First calculator     │
└─────────────────────────┘

120 ──
┌─────────────────────────┐
│    Second calculator    │
└─────────────────────────┘

211 ──
┌─────────────────────────┐
│ Obtain sensing data of battery │
└─────────────────────────┘

213 ──
┌─────────────────────────┐
│   Preprocess sensing data   │
└─────────────────────────┘

215 ──
┌─────────────────────────┐
│  Store preprocessed sensing │
│   data in first memory      │
└─────────────────────────┘

217 ──
◇ Transmission period is reached? ◇

No

Yes    Transmit

219 ──
┌─────────────────────────┐
│ Perform operation on battery │
└─────────────────────────┘

FIG. 2

Transmission
period (T)
310

Transmission
period (T)
310

$t_0$ $t_1$ $t_2$

· · ·

## FIG. 3

| Update aging parameter of battery model 410 | Update fast charging algorithm 420 | · · · |

## FIG. 4

FIG. 5

```
        ┌─────────────────┐
        │      Start      │
        └─────────────────┘
                 │
                 ▼                                          ╱ 610
 ┌──────────────────────────────────────────────────────────┐
 │  Generate plurality of pieces of basic simulation data for each of  │
 │      preset charging currents based on second battery model         │
 └──────────────────────────────────────────────────────────┘
                 │
                 ▼                                          ╱ 620
 ┌──────────────────────────────────────────────────────────┐
 │     Generate initial LUT for charging currents and preset battery   │
 │   voltage limits based on plurality of pieces of basic simulation data │
 └──────────────────────────────────────────────────────────┘
                 │
                 ▼                                          ╱ 630
 ┌──────────────────────────────────────────────────────────┐
 │       Generate modified LUT by adjusting one or more initial        │
 │            charging limit conditions of initial LUT                 │
 └──────────────────────────────────────────────────────────┘
                 │
                 ▼                                          ╱ 640
 ┌──────────────────────────────────────────────────────────┐
 │      Determine final LUT based on modified LUT in response to       │
 │            modified LUT satisfying preset condition                 │
 └──────────────────────────────────────────────────────────┘
                 │
                 ▼                                          ╱ 650
 ┌──────────────────────────────────────────────────────────┐
 │       Generate charging path for battery based on final LUT         │
 └──────────────────────────────────────────────────────────┘
                 │
                 ▼
        ┌─────────────────┐
        │       End       │
        └─────────────────┘
```

## FIG. 6

710-1  710                    720      730

| Interval | Charging current (A) | Battery voltage limit (V) | LUT1(V) | LUT2(V) | LUT3(V) | ... | LUT63(V) | LUT64(V) |
|---|---|---|---|---|---|---|---|---|
| 1 | 7.92 | 4.130 | 0.061 | 0.062 | 0.062 | ... | 0.062 | 0.062 |
| 2 | 7.57 | 4.130 | 0.061 | 0.061 | 0.061 | ... | 0.062 | 0.062 |
| 3 | 7.12 | 4.130 | 0.053 | 0.053 | 0.054 | ... | 0.062 | 0.052 |
| 4 | 6.67 | 4.300 | 0.038 | 0.038 | 0.038 | ... | 0.052 | 0.053 |
| 5 | 6.23 | 4.300 | 0.040 | 0.040 | 0.040 | ... | 0.054 | 0.054 |
| 6 | 5.79 | 4.300 | 0.041 | 0.041 | 0.041 | ... | 0.053 | 0.053 |
| 7 | 5.34 | 4.300 | 0.043 | 0.043 | 0.043 | ... | 0.052 | 0.052 |
| 8 | 4.89 | 4.300 | 0.046 | 0.046 | 0.046 | ... | 0.048 | 0.048 |
| 9 | 4.45 | 4.380 | 0.005 | 0.005 | 0.005 | ... | 0.005 | 0.005 |
| Charging time (min) | | | 27.13 | 27.13 | 27.13 | ... | 29.98 | 30.08 |
| Aging rate (mAh/cycle) | | | 0.1803 | 0.1802 | 0.1801 | ... | 0.1422 | 0.1413 |

710-2

FIG. 7

800

Mobile device

Processor
820

PMIC
810

Battery
830

**FIG. 8**

900

BMS

MCU
910

Processor
920

**FIG. 9**

```
┌────────────────────────────────────────────────── 1000
│                      Vehicle                      │
│  ┌─────────────────────┐   ┌──────────────────┐   │
│  │   Battery pack      │   │                  │   │
│  │      1010           │   │                  │   │
│  │  ┌─────────────┐    │   │   Processor      │   │
│  │  │    BMS      │◄───┼───┼──►    1020       │   │
│  │  │    1011     │    │   │                  │   │
│  │  └─────────────┘    │   │                  │   │
│  └─────────────────────┘   └──────────────────┘   │
└───────────────────────────────────────────────────┘
```

# FIG. 10

```
┌─────────────────────────┐       ┌─────────────────────────┐
│  Electronic apparatus   │       │    Cloud server         │
│         1110            │       │       1120              │
│  ┌──────────────────┐   │       │  ┌──────────────────┐   │
│  │      MCU         │◄──┼───────┼──►   Processor      │   │
│  │      1111        │   │       │  │      1112        │   │
│  └──────────────────┘   │       │  └──────────────────┘   │
└─────────────────────────┘       └─────────────────────────┘
```

# FIG. 11

Start

↓ 1210

Obtain, using sensor of electronic apparatus, sensing data of battery of electronic apparatus

↓ 1220

Determine, using first calculator of electronic apparatus, first state information of battery using obtained sensing data and first battery model

↓ 1230

Preprocess, using first calculator, obtained sensing data

↓ 1240

Transmit, using first calculator, preprocessed sensing data to second calculator of electronic apparatus

↓ 1250

Determine, using second calculator, aging state of battery using second battery model and received sensing data

↓ 1260

Update, using second calculator, parameter of first battery model using determined aging state

↓ 1270

Transmit, using second calculator, updated parameter to first calculator

↓ 1280

Apply, using first calculator, updated parameter to first battery model such that determined aging state is reflected in first battery model

↓

End

FIG. 12

**EP 4 390 418 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2016209472 A1